**Europäisches Patentamt**

**European Patent Office**

**Office européen des brevets**

(19)

(11) **EP 1 400 545 A2**

(12) **EUROPEAN PATENT APPLICATION**

(43) Date of publication:
24.03.2004 Bulletin 2004/13

(51) Int Cl.7: **C08F 290/04**, G03F 7/033,
G03F 7/085

(21) Application number: 03255964.3

(22) Date of filing: 23.09.2003

| | |
|---|---|
| (84) Designated Contracting States: **AT BE BG CH CY CZ DE DK EE ES FI FR GB GR HU IE IT LI LU MC NL PT RO SE SI SK TR** Designated Extension States: **AL LT LV MK** | (72) Inventors: • **Deuber, Thomas E. Wilmington, DE 19803 (US)** • **West, Michael W.J. Wilmington, DE 19803 (US)** |
| (30) Priority: **23.09.2002 US 412876 P** **15.10.2002 US 271370** | (74) Representative: **Towler, Philip Dean Frank B. Dehn & Co., European Patent Attorneys, 179 Queen Victoria Street London EC4V 4EL (GB)** |
| (71) Applicant: **E.I. DU PONT DE NEMOURS AND COMPANY Wilmington Delaware 19898 (US)** | |

(54) **Halo resistant photoimagable coverlay compositions**

(57) The invention relates to flexible, aqueous processible, photoimagable coverlay compositions, having advantageous adhesion and release properties and resistance to (unwanted) haloing. The coverlay compositions of the present invention comprise an acrylic, low Tg, graft copolymer binder component, having an alkali resistant backbone-segment and a pendant arm segment comprising hydrophilic moieties. Optionally, the coverlay further comprises a thiophene-type adhesion promoter to further improve adhesion properties.

**EP 1 400 545 A2**

**Description**

FIELD OF THE INVENTION

The present invention relates generally to flexible, aqueous processible, photoimagable coverlay compositions having advantageous adhesion and release properties and resistance to (unwanted) haloing. More specifically, the coverlay compositions of the present invention comprise an acrylic, low Tg, graft copolymer binder component having an alkali resistant backbone-segment and a pendant arm segment comprising hydrophilic moieties. Optionally, the coverlay further comprises a thiophene-type adhesion promoter to further improve adhesion properties.

BACKGROUND OF THE INVENTION

Photosensitive coverlay compositions are sometimes called "solder masks." These compositions are discussed broadly in US PAT NO. 5, 536,620 to Dueber et al. (the "Dueber" patent). WO 92/15628 is a published patent application directed to comb polymer binders useful for photosensitive compositions. The subject matter of this specification, the Dueber patent, and WO 92/15628 all arise from related research conducted by E. I. du Pont de Nemours and Company, Wilmington Delaware, USA. Numerous embodiments of the present invention can be synthesized and/ or used in accordance with the broad teachings of the Dueber patent and/or the WO 92/15628 published patent application. Therefore, both of these references (the Dueber patent and WO 92/15628) are hereby incorporated by reference into this specification for all teachings therein. Although related, the compositions and methods taught in the Dueber patent and the WO 92/15628 published application, either alone or in combination, possess technical shortcomings. These shortcomings are addressed by the present invention.

SUMMARY OF THE INVENTION

The present invention is directed to coverlay compositions having a binder component. The graft copolymer of the present invention is a binder component that provides, or enhances, advantageous coverlay adhesion properties. In a preferred embodiment, the coverlay's adhesive properties allow the coverlay to be repositioned (after initial contact with the substrate) so a user has the option of further aligning the coverlay (e.g., removing unwanted wrinkles) subsequent to any initial application. Moreover, the binders of the present invention generally enhance the coverlay's ability to impede unwanted (relative) movement between the coverlay and substrate, when application of the coverlay (to the substrate) is complete.

The binder compositions of the present invention are also advantageous due to the binder's hydrophilicity, which is generally useful when washing away unexposed coverlay (subsequent to photo-patterning) by means of a water based or similar-type cleaning chemistry. The binders of the present invention are particularly useful in applications requiring very low concentrations (if any) of unwanted residuals, subsequent to such cleaning. Also, exposed coverlay is often subjected to metal plating chemistry that can attack the coverlay and cause unwanted haloing. However, the binders of the present invention have a chemical structure that is generally resistant to such attack by metal plating chemistries.

The binder components of the present invention are dried graft copolymers having (i.) an acid number of 40 to 80 and (ii.) a calculated glass transition temperature (Tg) in the range having a lower limit of about 30, 35, 40, 45 or 50°C and an upper limit of about 55, 60, 65, 70, 75 or 80°C. Preferably the range has a lower limit of about 50, 55, or 60°C and an upper limit of about 60, 65 or 70°C. The graft copolymer binders of the present invention have a backbone segment and at least one arm segment grafted to the backbone. The weight average molecular weight ratio $(M_{w1}: M_{w2})$ of the binder backbone segment to the binder arm segment(s) is A:B, where A is 1 and B is a range having a lower limit of about 0.033, 0.04, 0.05, 0.1, 0.2, or 0.3, and an upper limit of about 0.3, 0.4, 0.5, 0.6, 0.7, 0.8, 0.9, 1.0, 1.2, 1.5, 1.75, 2, 2.2, 2.5, 2.7 or 3.

Optionally, the binder arm segment(s) are derived from ethylenically unsaturated macromer components having a weight average molecular weight ($M_w$) from 2,000 to 15,000. In another embodiment, the binder acid number is further defined as having a backbone component and an arm segment(s) component, wherein at least 50, weight percent for example at least 55, 60, 65, 70, 75, 80, 85, 90, 95, 96, 97, 98, 99, or 100 weight percent of the acid groups are located on the arm segment(s) with the balance being located on the backbone segment. Preferably, at least 75, 80, 85, 90, 95, 96, 97, 98, 99, or 100 weight percent of the acidic monomer portion is located in the arm segment, and the balance of the acidic monomer portions are located in the backbone segment.

Preferably, the arm segment(s) has a calculated glass transition temperature (Tg) in a range having a lower limit of about 90, 95, 100, 105, 110, 115, 120, 125, 130, 135, 140, or 145°C and an upper limit of about 150, 155, 160, 165, 170, 175, 180, 185, 190, 195 or 200°C.

Optionally, the average Tg of the arm segment(s) is in a range having a lower limit of about 90°C to 200°C, preferably from 110°C to 160°C. In such an embodiment, the Tg of the backbone segment is sufficiently low to provide an overall Tg for the entire binder component as discussed above, e.g., 30-80°C, which is the broadest overall Tg range discussed above for the entire binder component (with more narrow ranges also described above). Preferably the backbone segment has a calculated glass transition temperature (Tg) in a range having a lower limit of about 20, 25 or 30°C and an upper limit of about 35, 40, 45 or 50°C.

Optionally, the coverlay compositions of the present invention further comprise an adhesion promoter. The preferred adhesion promoters of the present invention comprise:

   a. a thiophene having an -H or -SH on the 2 position carbon (on one side of the sulfur) and an $-NH_2$ on the 5 position carbon (on the other side of the sulfur); and
   b. a nitrogen substituted thiophene ring, wherein nitrogen is substituted at the thiophene ring:

      i. 3 position;
      ii. 4 position; or
      iii. both the 3 position and the 4 position and

   wherein -H or -SH on the 2 position carbon and an $-NH_2$ is on the 5 position carbon.

DETAILED DESCRIPTION OF THE PREFERRED EMBODIMENTS

The following discussion is directed to the preferred embodiments of the present invention only, and nothing within the following disclosure is intended to limit the overall scope of the present invention. The scope of the present invention is to be defined solely by the claims, as presented at the end of this specification.

The preferred photosensitive coverlay compositions of the present invention are used to protect the delicate circuit traces (fragile metal circuit patterns) which would otherwise be exposed at the surface of the flexible circuit or which would otherwise be susceptible to damage. In one embodiment of the present invention, the coverlay composition is placed over the circuit traces as a sheet and vacuum-pressed, and/or roll-pressed, thereby bonding the coverlay onto the circuit traces.

In such embodiments, coverlay passageways can be formed via any conventional or non-conventional photo imaging process. The photo imaging can be done by applying electromagnetic radiation through a pattern (commonly called a photo mask), so the radiation exposes only certain pre-defined portions of the coverlay. These (exposed) portions will typically have much lower aqueous carbonate solubility properties than the remaining unexposed portions, due at least in part to crosslinking, chain extension, and other chemical reactions in the photo sensitive coverlay.

In such embodiments, the coverlay can then be subjected to an aqueous carbonate removal process. The differential in solubility between the exposed and unexposed portions (due to photo imaging) will generally cause the unexposed portions of the coverlay to swell and dissolve (or otherwise be removed). As portions of the coverlay are removed, passageways (through the coverlay) can be formed. Subsequently, these passageways are typically filled with metal, via a metal deposition chemistry and process.

The photosensitive coverlay compositions of the present invention are advantageous because the binder component provides the unexposed coverlay with optimal hydrophilicity and a high degree of aqueous carbonate solubility. Photo imaging exposure will generally cause the binder to be contained in an interpenetrating photopolymer network during the photoimaging step. Hence, the exposed portion of the coverlay will remain in place, while the unexposed portion will readily wash away in an appropriate aqueous carbonate developer. The high-acid arm portions of the binder have been found to be extremely efficient in suspending (or solubilizing) the unexposed portion in the aqueous carbonate solution. Indeed in certain embodiments, the coverlay compositions of the present invention are sufficient to meet the latest industry requirements for low (amounts of) residue after passageway creation.

Once such a passageway is created, metals such as nickel or gold are often electroplated into the passageway, thereby forming a metal interconnect that extends from a circuit trace along the passageway towards the coveday's outer surface. Such 'plated-up' metal interconnects can be used later as solder mount locations for supplying electrical inputs and electrical outputs to the circuit traces.

Oftentimes, electroless nickel immersion gold plating baths can cause unwanted "haloing," i.e., defects imposed upon the coverlay in close proximity to the passageways due to chemical attack from the plating bath. Hydrogen gas bubbles are released during nickel immersion plating that can result in edge delaminations along the passageway if the photoimageable coverlay adhesion is not sufficient. In addition, hydroxide ion can form during this plating process, which can cause reduced adhesion between the coverlay and the copper surface, leading to (undesired) haloing, delamination and/or underplating. In many embodiments, the coverlay compositions of the present invention have been found to be particularly resistant to such defects.

Residue left after development can impede plating. To achieve low residue and low haloing, the photosensitive coverlay compositions of the present invention comprise a binder having an appropriate acid number in an appropriate configuration. In other embodiments, adhesion promoters are used to provide both adhesion of the photoimageable coverlay to the flexible circuit, and to also allow sufficient development, thereby minimizing post development residue that might otherwise impede metal plating.

In certain embodiments, the coverlay compositions of the present invention have advantageous aqueous processability and also chemical resistance to acidic and caustic attack (i.e. hydroxide ion). This can be done while also maintaining other essential properties of the coverlay formulation, such as, low tackiness, high glass transition temperature, photosensitivity, low post-development residue, flexibility, adhesion and optionally flame retardancy.

The preferred binder compositions of the present invention will now be described. The binder compositions of the present invention are graft copolymers (sometimes referred to as 'comb' polymers) having two main portions, a backbone polymer segment and an arm polymer segment(s). The arm segment(s) is/are made from large monomers known as macromers. The macromers of the present invention are derived from a variety of acrylate compounds. These macromers are generally grafted onto the backbone polymer segment to form the arms of the graft copolymer.

The graft copolymer contains hydrophilic groups in the arm segments of the graft copolymer. The graft copolymer comprises arm segments chemically linked along a linear polymer backbone segment. The graft copolymer is typically formed during free radical addition polymerization of at least one macromer component comprised mainly of methyl methacrylate (MMA) and methacrylic acid (MAA) as the arm segment, and other acrylate comonomers as the linear polymer backbone segment. The macromer component (typically referred to herein as the 'arm segment') in such an embodiment has a number average molecular weight (Mn) of between 1,000 to 5,000, preferably 1,000 to 2,000. The graft copolymer has a number average molecular weight of from 8,000 to 30,000 and preferably 8,000 to 20,000. Too high a molecular weight in the arm segments will often cause excess residue formed during development of the coverlay.

In one embodiment, the optimum weight percent of methacrylic acid (MAA) in the graft copolymer is in a range having a lower end of about 5, 5.5, 6, 6.5, 7, 7.5 or 8 wt. % and an upper end of about 8, 8.5, 9, 9.5, or 10 wt. %. In one embodiment, 8.7 wt. % is preferred. In one embodiment, it is necessary for at least 90 % of the methacrylic acid to reside in the arms of the graft copolymer. Too high an overall acid number in the graft copolymer, or too high an acid number in the linear backbone of the graft copolymer, will tend to allow halo defects to form after electroplating of metal, such as nickel and/or gold, at least generally speaking.

Acrylate monomers useful in forming the macromer arm polymer segments of the present invention include methyl methacrylate (MMA), methacrylic acid (MAA), ethyl methacrylate (EMA), butyl methacrylate (both n-butyl and isobutyl), 2-ethylhexyl methacrylate (EMA), and 2-hydroxyethyl methacrylate (HEMA). In one embodiment, methyl methacrylate (MMA) and methacrylic acid (MAA) is preferred.

Other monomer components can be used in preparing the graft copolymers of the present invention. In addition to the macromers discussed above, useful additional monomers include pentabromobenzyl acrylate (PBA), benzyl acrylate (BA), dibromostyrene (DBS), ethyl acrylate (EA), methyl methacrylate (MMA), isobutyl acrylate (iBA), n-butyl acrylate (nBA), hydroxyethyl acrylate (HEA), hydroxyethyl methacrylate (HEMA), acrylonitrile and isobornyl acrylate.

In one embodiment, the polymeric arm segments contain from about 90% to 100% of the total hydrophilic groups present on the graft copolymer. Preferred hydrophilic groups are protic groups such as hydroxy, amino, ammonium, amido, imido, urethano, ureido, or mercapto; or carboxylic, sulfonic, sulfinic, phosphoric, or phosphonic acids or salts thereof. Preferably, the hydrophilic groups are acid groups and particularly preferred are carboxylic acid groups, although other groups such as hydroxy groups may also be present.

In one embodiment, the acid containing graft copolymers of the present invention typically will contain between about 8% to about 9% by weight acidic monomer based on the total monomer composition. But, the graft copolymer can contain between from about 5, 5.5, 6, 6.5, 7, or 7.5% to about 7, 7.5, 8, 8.5, 9, 9.5 or 10%. When the hydrophilic groups are acid groups, the graft copolymer preferably has an acid number between about 40 and about 80, more preferably between about 50 and about 60.

As stated earlier, the photosensitive compositions of this invention contain novel graft copolymers having arm polymer segments of limited molecular weight and a limited weight ratio relative to the linear polymer backbone segment. The arm polymer segments typically contain the majority of the hydrophilic groups present in the graft copolymer product.

The overall molecular weight (Mw) of the graft copolymer is typically between 20,000 and 60,000 for example, the overall molecular weight (Mw) of the graft copolymer is in a range beginning at 20,000, 25,000, 30,000, 35,000, or 40,000 and ending at 45,000, 50,000, 55,000, or 60,000. Preferably, the weight average molecular weight of the graft copolymer is between 20,000 and 30,000. In one embodiment, the weight ratio of the linear polymer backbone to the arm polymer segment(s) is within a range of A/B where A is about 0.033, 0.04, 0.05, 0.1, 0.2, or 0.3, to about 0.3, 0.4, 0.5, 0.6, 0.7, 0.8, 0.9, 1.0, 1.2, 1.5, 1.75, 2, 2.2, 2.5, 2.7 or 3. Generally, the macromer component (or arm segment) has a weight average molecular weight (Mw) of from about 2,000 to 15,000. Preferably the macromer component weight average molecular weight (Mw) is from about 2000, 2200, 2400, 2600, 2800 or 3000 to about 3200, 3400, 3600, 3800 or 4,000.

In one embodiment, the graft copolymer contains at least 50, for example at least 55, 60, 65, 70, 75, or 80% by weight of backbone segments. The backbone segments, which are typically linear, have distributed on them polymer arm segments. The polymer arm segments are polymers or oligomers of at least two repeating monomer units, which are attached to the linear backbone polymer segment by a covalent bond. The arm segment is incorporated into the graft copolymer as a macromer component during the addition polymerization process of both macromer components and other comonomers.

In one embodiment of the present invention, the macromer used as the arm polymer segment contains acid functionality groups. These acid groups make the graft copolymer hydrophilic and soluble (when unexposed to ultraviolet light) in an aqueous carbonate developer bath. When the graft copolymer has too low an overall acid number, the photosensitive solder mask composition will often leave a residue in the portions of the coverlay that are unexposed. If the graft copolymer has too high an acid number, the photoimagable coverlay composition will often have inadequately resistance to hydroxide ion attack in an electroplating bath. Hydroxide ion attack, found to occur in the electroless nickel/immersion gold plating solutions, was surprisingly discovered to be the cause of many failures in prior art photosensitive solder masks.

In one embodiment, for the photosensitive solder mask composition to resist a nickel and/or gold plating solution, the photosensitive composition must generally have a low overall acid number. Low acid number of the photosensitive composition generally helps to greatly reduce the effects of a neutralization reaction that occurs when hydroxide ions attack the protective solder mask layer. To lower the overall acid number of the photosensitive solder mask, a class of graft copolymers were found to be useful, particularly which develop with a lower acid number than that of the linear polymer in conventional photosensitive solder masks. Moreover, a graft copolymer structure is often an ideal structure for advantageously placing certain functionality at one point in the polymer while eliminating that same functionality at other portions of the polymer.

In one embodiment, the graft copolymers of the present invention have an acid functionality that is preferably placed along the arms of the graft copolymer, away from the backbone segment. Because a relatively low amount of acid functionality is used, base ion attack from an electroplating bath is generally minimized. In this fashion, the acid functionality is sufficient for the photosensitive solder mask composition to be developed with conventional aqueous carbonate developer, but chemical resistance is (advantageously) not unduly compromised during the electroplating steps.

In one embodiment, macromer compositions of the binder component preferably comprise MMA and MAA monomers. These macromers typically make up the arm segment(s) of the graft copolymers of the present invention. Because most, or all, of the acidic functionality is contained in the macromer itself, the acid number of the graft copolymer can often be lower than for a linear polymer, but still typically provides sufficient aqueous carbonate developability. The preferable ratio of MMA to MAA (acid) can often be determined by the following expression:

$$(\text{wt . fraction of MAA in the arm segment}) \times (\text{wt.\% arm segment in the graft copolymer}) = 8.7$$

For different wt. % macromer (arm segment) in the graft copolymer, the calculated level of MAA in the arm segment can be described according to the table below:

| Wt % arm segment | Wt fraction MAA in arm segment |
|---|---|
| 10 | 0.87 |
| 20 | 0.435 |
| 30 | 0.29 |
| 40 | 0.2175 |
| 50 | 0.174 |

A broader range of weight fractions is often possible however. In a preferred embodiment the weight ratio of the methyl methacrylate (MMA) portion to the methacrylic acid (MAA) portion contained in the arm segment (typically the macromer) is represented by the ratio C/D wherein C is in a range beginning at 40, 45, 50 or 55 and ending at 55, 60, 65, 70, 75, 80, 85 or 90 and D is in a range beginning at 60, 55, 50, or 45 and ending at 45, 40, 35, 30, 25, 20, 15, or 10.

In a broader embodiment, an equation can be written expressed by the formula: (the weight fraction of MAA in the macromer) x (wt. % macromer in the graft copolymer) equals a number in a range beginning at 5.5, 5.7, 6.0, 6.2, 6.5, 6.7, 7, 7.2, 7.5, 7.8, 8.0, 8.2, 8.5, or 8.7 and ending at 8.7, 9.0, 9.2, 9.5, 9.7, 10, 10,2, 10.5, 10.7, 11, 11.2, or 11.5.

If the weight average molecular weight, ($M_w$), of the graft copolymer, or the macromer, is above the preferred ranges listed above problems can sometimes occur. For example unwanted (additional) 'post-development residue' can occur at the unexposed portion of the coverlay after development. In addition, when immersed in an electroless Ni/Au plating bath, plating uniformity can be adversely effected.

In certain embodiments, the Tg of the graft copolymer can be important because the amount of tack that the coated photoimageable coverlay has can be important. Generally, the tack should be relatively low so that the photoimageable coverlay (e.g., pre-coated on a Mylar® brand polyester support film) can be repositioned as needed over the flexible circuit prior to vacuum lamination. If the coating is too tacky (with respect to the flexible circuit), repositioning is often not possible and air entrapment may result from areas of the coverlay that wrinkle. The present invention provides a meaningful correlation between tack and Tg of the graft copolymer. The Fox equation is used to calculate the theoretical Tg of the graft copolymer.

In one embodiment, the macromer (arm segment) Tg has a high theoretical Tg, about 134°C, when the preferential methyl methacrylate/methacrylic acid macromer (arm segment) is used. Typically, the Tg of the arm segment is in the range of 90 to 200°C and preferably from 110 to 160°C. When the backbone Tg, as predicted by the Fox equation, is above 20°C there is generally relatively low tack in the photoimageable coverlay. This typically allows repositioning of the coating over the flexible circuit prior to lamination. The graft copolymer of EXAMPLE 2 in WO 92/15628 has a calculated Tg for the backbone of -17°C and the calculated Tg for the total graft copolymer of 3°C. The photoimageable coverlay formed using this graft copolymer is generally too tacky to allow repositioning of the coating over a flexible circuit prior to lamination.

In many embodiments of the present invention, the overall calculated Tg of the preferred graft copolymers is between 50°C to 70°C. The actual Tg of the graft copolymers is generally expected to be lower than the predicted values, due to the molecular weights in the range of 20,000, 25,000, 30,000, 35,000, or 40,000 to about 45,000, 50,000, 55,000, 60,000. However, using the Fox equation generally helps predict which graft copolymers will yield low tack photoimageable coverlay formulations and which oftentimes will not. Thus, it can be important in certain embodiments of the present invention that the graft copolymer have a calculated Tg of the backbone be above 20°C in order that the Tg of the overall graft copolymer be in the preferred range of 50°C to 70°C.

The following Table illustrates a summary of the properties preferred (in many embodiments) of the graft copolymer.

| Property of graft copolymer | General range | Preferred Range |
|---|---|---|
| $M_n$ of macromer | 1,000 to 5,000 | 1,000 to 2,000 |
| $M_n$ of graft copolymer | 8,000 to 30,000 | 8,000 to 20,000 |
| $M_w$ of macromer | 2,000 to 15,000 | 2,000 to 4,000 |
| $M_w$ of graft copolymer | 20,000 to 60,000 | 20,000 to 30,000 |
| Tg calculated (°C) | | |
|     Arm | 90 to 200 | 110 to 160 |
|     Backbone | 20 to 50 | 25 to 40 |
|     Graft copolymer | 30 to 80 | 50 to 70 |
| Acid number | | |
|     Graft copolymer | 40 to 80 | 50 to 60 |
|     Photosensitive coverlay | 15 to 50 | 20 to 40 |

## PHOTOSENSITIVE COMPOSITIONS

In many embodiments of the present invention, the compositions further comprise additional components. These components can be catalysts, adhesion promoters, flame retardant additives, photo-initiators and the like. These components can be used to render the compositions reactive to thermal and/or radiant energy thereby making the compositions useful in a variety of photoimagable coverlay applications.

The graft copolymers can be particularly useful in UV sensitive compositions containing at least one photo active and/or thermally active component, and in particular in photosensitive compositions such as photo resists, solder masks, and the like, which will be further described to illustrate this invention.

"Photo active," which is synonymous with "photosensitive," describes a material which changes its chemical or physical nature, or causes such a change, upon exposure to actinic radiation, in such a way that the change is formed directly. Examples include an image, or a precursor (a latent image is formed which upon further treatment produces the desired change.

"Thermally active" describes a material that changes its chemical or physical nature (or causes such a change) when its temperature is raised or when a substance is added or removed. Illustrative of such a photo active or thermally active component is a material which cyclizes, dimerizes, polymerizes, crosslinks, generates a free radical, generates an ionic species or dissociates upon exposure to actinic radiation or when it is heated.

Examples of photo active or photosensitive components are photo-initiators, photo-sensitizers, or a combination thereof, photosolubilizers, photodesensitizer, photoinhibitor, phototackifier, photodetackifier, or a component which is photodegradable, photochromic, photoreducible, photo-oxidizable, photoadhesive, photoreleaseable, photomagnetic, photodemagnetic, photoconductive or photoinsulative, or is a material which changes or causes changes in refractive index upon exposure to actinic radiation. Such photosensitive compositions of this invention include:

   (i) a polymerizable monomer, and
   (ii) an initiating system activatable by actinic radiation.

In one embodiment, the graft copolymers of the present invention are useful as components of photosensitive systems and particularly in photoimaging systems such as those described in "Light-Sensitive Systems: Chemistry, and Application of Nonsilver Halide Photographic Processes" by J. Kosar, John Wiley & Sons, Inc., 1965 and more recently in "Imaging Processes And Materials - Neblette's Eighth Edition" Edited by J. Sturge, V. Walworth and A. Shepp, Van Nostrand Reinhold, 1989. In such systems, actinic radiation impinges on a material containing a photoactive component to induce a physical or chemical change in that material. A useful image, or latent image, can be processed and produced. Typically actinic radiation useful for imaging is light ranging from the near ultraviolet through the visible spectral regions, but in some instances may also include infrared, deep-ultraviolet, X-ray and electron beam radiation.

Although the graft copolymer itself may be photo active, generally a photosensitive composition (containing one or more photoactive components) is used in addition to the graft copolymer. Upon exposure to actinic radiation, the photo active component generally acts to change the rheological state, the solubility, the surface characteristics, refractive index, the color, the electromagnetic characteristics and/or other such physical or chemical characteristics of the photosensitive composition, such as is described in the Neblette's publication identified above.

The photosensitive compositions of this invention can be used in the form of a supported film or layer, although unsupported solid objects may also be prepared. The photosensitive composition can generally be applied to a suitable substrate to form a continuous film or layer thereon which can then be exposed to actinic radiation to form an image directly (or a latent image).

Alternatively, the supported layer may be uniformly exposed to actinic radiation to cure or harden the layer, particularly when the photosensitive composition is applied either in the form of a continuous or patterned layer, such as, a protective finish, a paint or ink. Any conventional source of actinic radiation may be used including arc, discharge, and incandescent lamps as well as lasers, X- ray and electron beam units. The layer may be applied as a solution and dried to a solid layer wherein any conventional coating or printing process may be used. Alternatively, the layer or film may be applied by laminating a supported solid photosensitive layer to the substrate and then optionally removing the support.

In some reversal imaging processes, the treatment step can be used to complete the formation of the latent image before or during development. Such systems include photopolymer systems, e.g., as disclosed in US PAT. NO. 4,198,242 to Pazos or US PAT. NO. 4,477,556 to Dueber et al. (both of which are hereby incorporated into this specification by reference, for teachings therein), containing a photoinhibitor wherein imaging exposure generates inhibitor in the exposed areas of the layer and a subsequent uniform exposure to actinic radiation, or in some instances uniformly heated, generates a latent image in the complimentary areas free of photogenerated inhibitor. Such reversal systems also include photodesensitizable systems, e.g., as disclosed in Roos US PAT. NO. 3,778,270, wherein, in the exposed areas, a component required for image or latent image formation is degraded or desensitized to an inactive form and the component in the unexposed areas is developed into an image or latent image by subsequent treatment with a reagent.

Illustrations of such photosensitive systems are described in Chapter 7, "Polymer Imaging" by A. B. Cohen and P. Walker in Neblette's supra, pages 226-262, in which photocrosslinking, photodimerization, photocyclization, photosolubilization, and both ionic and free radical photopolymerization, as well as electrostatic photopolymer imaging and solid imaging are discussed. In Chapter 8, "Low Amplification Imaging Systems by R. Dessauer and C. E. Looney, pages 263-278, imaging systems discussed include color forming free radical, diazo, and vesicular systems, photochromism, phototackification and photodetackification as well as thermal and photothermal systems.

PHOTOPOLYMERIZABLE COMPOSITIONS

In one embodiment, the graft copolymers of the present invention are particularly useful in photopolymerizable compositions that contain a monomeric material and a photo-initiator system. In such systems, the graft copolymer can act as a dispersible polymeric binder component to impart desired physical and chemical characteristics to the exposed and unexposed photopolymerizable composition. Upon exposure to actinic radiation, the photo-initiator system induces chain-propagated polymerization of the monomeric material by a condensation mechanism or by a free radical addition polymerization reaction.

While all photopolymerizable mechanisms are contemplated, the compositions and processes of this invention will be described in the context of free radical initiated addition polymerization of monomers having one or more terminal ethylenically unsaturated groups. In this context, the photo-initiator system when exposed to actinic radiation acts as a source of free radicals needed to initiate polymerization of the monomer. The photo-initiator of the system is typically activated by a photo-sensitizer that absorbs actinic radiation. The absorption frequency of the photo-initiator may be outside the absorption spectrum of the initiator itself to sensitize the addition polymerization in more practical radiation spectral regions such as near ultraviolet, near visible light and near infrared. In the narrow sense, the term "photo active component" of this invention refers to the material that absorbs the actinic radiation. Examples are the photo-initiator or the photo-sensitizer. But, in the broader sense, the term "photo active" refers to any or all the essential materials needed for photopolymerization (i.e. the photo initiating system and the monomer).

Photopolymerizable compositions contain the graft copolymers, an initiating system activated by actinic radiation, and at least one nongaseous ethylenically unsaturated compound having a boiling point above 100°C at normal atmospheric pressure and being capable of forming a high polymer by photoinitiated addition polymerization. Preferred photopolymerizable compositions contain 'mono' or 'poly' functional acrylates or methacrylates and particularly preferred are such compositions containing monomers with two, three or more acrylate or methacrylate groups to allow concurrent crosslinking during the photopolymerization process.

ADDITION POLYMERIZABLE MONOMERS

Suitable monomers which can be used as the sole monomer or in combination with others include the following: t-butyl acrylate, 1,5-pentanediol diacrylate, N,N'-diethylaminoethyl acrylate, ethylene glycol diacrylate, 1,4-butanediol diacrylate, diethylene glycol diacrylate, hexamethylene glycol diacrylate, 1,3-propanediol diacrylate, decamethylene glycol diacrylate, decamethylene glycol dimethacrylate, 1,4-cyclohexanediol diacrylate, 2,2-dimethylolpropane diacrylate, glycerol diacrylate, tripropylene glycol diacrylate, glycerol triacrylate, trimethylolpropane triacrylate, pentaerythritol triacrylate, polyoxyethylated trimethylolpropane triacrylate and trimethacrylate and similar compounds as disclosed in US PAT. NO. 3,380,831, 2,2-di(p-hydroxyphenyl)-propane diacrylate, pentaerythritol tetraacrylate, 2,2-di-(p-hydroxyphenyl)- propane dimethacrylate, triethylene glycol diacrylate, polyoxyethyl-2,2-di-(p-hydroxyphenyl)-propane dimethacrylate, di-(3-methacryloxy-2-hydroxypropyl)ether of bisphenol-A, di-(2-methacryloxyethyl) ether of bisphenol-A, di-(3-acryloxy-2-hydroxypropyl) ether of bisphenol-A, di-(2-acryloxyethyl) ether of bisphenol-A, di-(3-methacryloxy-2-hydroxypropyl) ether of tetrachloro-bisphenol-A, di-(2-methacryloxyethyl) ether of tetrachloro-bisphenol-A, di-(3-methacryloxy-2- hydroxypropyl) ether of tetrabromo-bisphenol-A, di-(2- methacryloxyethyl) ether of tetrabromo-bisphenol-A, di- (3-methacryloxy-2-hydroxypropyl) ether of 1,4- butanediol, di-(3-methacryloxy-2-hydroxypropyl) ether of diphenolic acid, triethylene glycol dimethacrylate, ethylene glycol dimethacrylate, butylene glycol dimethacrylate, 1,3-propanediol dimethacrylate, 1,2,4- butanetriol trimethacrylate, 2,2,4-trimethyl-1,3- pentanediol dimethacrylate, pentaerythritol trimethacrylate, 1-phenyl ethylene-1,2-dimethacrylate, pentaerythritol tetramethacrylate, trimethylol propane trimethacrylate, 1,5-pentanediol dimethacrylate, diallyl fumarate, styrene, 1,4-benzenediol dimethacrylate, 1,4- diisopropenyl benzene, and 1,3,5-triisopropenyl benzene.

A class of monomers is alkylene or a polyalkylene glycol diacrylates prepared from an alkylene glycol of 2 to 15 carbons or a polyalkylene ether glycol of 1 to 10 ether linkages, and those disclosed in US PAT. NO. 2,927,024 e. g., those having a plurality of addition polymerizable ethylenic linkages particularly when present as terminal linkages. Preferred are those wherein at least one and preferably most of such linkages are conjugated with a double bonded carbon, including carbon double bonded to carbon and to such hetero atoms as nitrogen, oxygen and sulfur. Also preferred are such materials wherein the ethylenically unsaturated groups, especially the vinylidene groups, are conjugated with ester or amide structures.

A particularly preferred class of monomers are, hexamethylene glycol diacrylate, ethoxlated 1,6-hexanediol diacrylate, acrylated aromatic urethane oligomer, triethylene glycol diacrylate, tripropylene glycol diacrylate, pentaerythritol triacrylate, trimethylolpropane triacrylate, polyoxyethylated trimethylolpropane triacrylate, di-(3-acryloxy-2-hydroxypropyl) ether of bisphenol-A, di-(3-acryloxy-2-hydroxypropyl) ether of tetrabromo-bisphenol-A, or methacrylate analogues of di-(3-acryloxy-2-hydroxypropyl) ether of tetrabromo-bisphenol-A.

PHOTO-INITIATOR SYSTEMS

The photo-initiator system has one or more compounds that directly furnish free-radicals when activated by actinic radiation. The system also may contain a sensitizer that is activated by the actinic radiation, causing the compound to furnish the free-radicals.

Photo-initiator systems of the present invention typically contain a photo-sensitizer that extends spectral response into the near ultraviolet, visible, and near infrared spectral regions. A large number of free-radical generating compounds, including redox systems such as Rose Bengal/2-dibutylaminethanol, may be selected to advantage. Photoreducible dyes and reducing agents such as those disclosed in US PAT. NOs.: 2,850,445; 2,875,047; 3,097,096; 3,074,974; 3,097,097; 3,145,104; and 3,579,339; as well as dyes of the phenazine, oxazine, and quinone classes; ketones, quinones; 2,4,5- triphenylimidazolyl dimers with hydrogen donors, and mixtures thereof as described in US PAT. NOs.; 3,427,161; 3,479,185; 3,549,367; 4,311,783; 4,622,286; and 3,784,557 can be used as initiators. Other initiators are dye-borate complexes disclosed in US PAT. NO. 4,772,541; and trichloromethyl triazines disclosed in US PAT. NOs. 4,772,534 and 4,774,163. A useful discussion of dye sensitized photopolymerization can be found in "Dye Sensitized Photopolymerization" by D. F. Eaton in Adv. in Photochemistry, Vol. 13, D. H. Volman, G. S. Hammond, and K. Gollinick, eds., Wiley- Interscience, New York, 1986, pp. 427-487. Similarly, the cyclohexadienone compounds of US PAT. NO. No. 4,341,860 are useful as initiators.

Preferred photo-initiators include CDM-HABI, i.e., 2-(o-chlorophenyl)-4,5-bis (m-methoxyphenyl)-imidazole dimer; o-Cl-HABI, i.e., 1,1'-biimidazole, 2,2'-bis(o- chlorophenyl)-4,4',5,5'-tetraphenyl; and TCTM-HABI, i.e., 1H-imidazole, 2,5-bis(o-chlorophenyl)-4-[3,4- dimethoxyphenyl] dimer, each of which is typically used with a hydrogen donor. Sensitizers useful with photoinitiators include methylene blue and those disclosed in US PAT. NOs. 3,554,753; 3,563,750; 3,563,751, 3,647,467; 3,652,275; 4,162,162; 4,268,667; 4,351,893; 4,454,218; 4,535,052; and 4,565,769. A preferred group of sensitizers include the bis(p-dialkylaminobenzylidene) ketones disclosed in US PAT. NO. 3,652,275 to Baum et al., and the arylyidene aryl ketones disclosed in US PAT. NO. 4,162,162 to Dueber.

Preferred sensitizers include the following: DBC, i.e., cyclopentanone; 2,5-bis-{[4-(diethylamino)-2-methylphenyl]-methylene}; DEAW, i.e., cyclopentanone, 2,5-bis{[4-(diethylamino)-phenyl]methylene}; dimethoxy- JDI, i.e., inden-I-one, 2,3-dihydro-5,6-dimethoxy-2-[(2,3,6,7-tetrahydro-IH,5H-benzo[i,j]-quinolizin-9- yl)methylene); and JAW, i.e., cyclopentanone, 2,5- bis[(2,3,6,7-tetrahydro-IH,5H-benzo[i,j]quinolizin-I-yl)methylene].

Other particularly useful sensitizers are cyclopentanone, 2,5-bis[2-(1,3-dihydro-1,3,3-trimethyl- 2H-indol-2-ylidene) ethylidene], CAS 27713-85-5; and cyclopentanone, 2,5-bis[2-(I-ethylnaphtho[1,2-d]thiazol- 2(IH)-ylidene)ethylidene], CAS 27714-25-6. Hydrogen donor compounds that function as chain transfer agents in the photopolymer compositions include: 2-mercaptobenzoxazole, 2-mercaptobenzothiazole, 4-methyl-4H-1,2,4-triazole-3-thiol, etc.; as well as various types of compounds, e.g., (a) ethers, (b) esters, (c) alcohols, (d) compounds containing allylic or benzylic hydrogen, (e) acetals, (f) aldehydes, and (g) amides disclosed in column 12, lines 18 to 58 of US PAT. NO. 3,390,996 to MacLachlan. Suitable hydrogen donor compounds for use in systems containing both biimidazole type initiator and N-vinyl carbazole are 5-chloro-2-mercaptobenzothiazole; 2-mercaptobenzothiazole; 1 H-1,2,4-triazole-3-thiol; 6-ethoxy-2- mercaptobenzothiazole; 4-methyl-4H-1,2,4-triazole-3-thiol; 1-dodecanethiol; and mixtures thereof.

Another preferred class of photoinitiators and photo-sensitizers are benzophenone, Michler's ketone, ethyl Michler's ketone, p-dialkylaminobenzaldehydes, p-dialkylaminobenzoate alkyl esters, polynuclear quinones, thioxanthones, hexaarylbiimidazoles, cyclohexadienones, benzoin, benzoin dialkyl ethers, or combinations thereof wherein the alkyl group contains 1 to 4 carbon atoms.

CROSSLINKING AGENTS

When the photopolymerizable composition is to be used as a permanent coating, such as a solder mask, a chemically or thermally activated crosslinking agent may be incorporated to improve high temperature characteristics, chemical resistance or other mechanical or chemical properties. Suitable crosslinking agents include those disclosed in US PAT. NO. 4,621,043 to Gervay, and U.S. PAT. NO. 4,438,189 to Geissler et al., such as melamines, ureas, benzoguanamines, and the like.

Examples of suitable crosslinking compounds include: N-methylol compounds of organic carboxamides such as N,N'-dimethylolurea, N,N'-dimethyloloxamide, N,N'-dimethylolmalonamide, N,N'-dimethylolsuccinimide, N,N'-dimethylolsebacamide, N,N',N"-trimethylolcitramide, 1,3-dimethylolimidazolidine-2-one, 1,3-dimethylol-4,5-dihydroxyimidazidine-2-one, 1,3- dimethylolperhydropyrimidine-2-one, trimethylolmelamine, tetramethylolmelamine, hexamethylolmelamine, 1,3-dimethylol-5-methylperhydro-1,3,5-triazine-2-one, 1,3-dimethylol-5-allylperhydro-1,3,5-triazine-2-one, 1,3- dimethylol-5-butylperhydro-1,3,5-triazine-2-one, 1,2- bis-[1,3-dimethylolperhydro-1,3,5-triazine-2-one-5-ylethane, tetramethylolhydrazine dicarboxamide, N,N'-dimethylolterephthalamide, N,NI-dimethylo lbenzene-1,3- disulfonamide and tetramethylolglycoluril; and C- methylol compounds of phenols, phenol-ethers and aromatic hydrocarbons 2,4,6-trimethylolphenol, 2,6-dimethylol-4-methyloanisole, 2,6-dimethylol-4- methylphenol, 1,3-dimethylol-4,6-diisopropylbenzene, 2,2-bis-(4-hydroxy-3,5-dimethylolphenyl)propane, and 3,3'-dimethylol-4,4'-dihydroxydiphenyl sulfone.

Instead of the aforementioned methylol compounds, it is also possible to use, for example, the corresponding methyl, ethyl or butyl ethers, or esters of acetic acid or propionic acid. Suitable examples include: 4,4'-bismethoxymethyldiphenyl ether, tris- methoxymethyldiphenyl ether, tetrakis-methoxymethyl hydrazinedicarboxamide, tetrakis-methoxymethyl- glycoluril, tetrakis-hydroxyethoxymethylglycoluril, bis-acetoxymethyldiphenyl ether, hexamethoxymethyl-melamine. In one embodiment, a preferred crosslinking agent of this class is hexamethoxymethyl melamine.

Other useful crosslinking agents are compounds containing two or more epoxy groups such as the bis-epoxides disclosed in US PAT. NO. 4,485,166 to Herwig et al. Suitable bis-epoxides include bis-glycidal ethers of dihydric alcohols and phenols such as bisphenol A, of polyethylene glycol and polypropylene glycol ethers of bisphenol A, of butane-1,4-diol, hexane-1,6-diol, polyethylene glycol, propylene glycol or polytetrahydrofurane. Bis-glycidyl ethers of trihydric alcohols, such as glycerol, or of halogenated bisphenol A, such as tetra-bromo bisphenol A, can also be used. Preferred crosslinking agents of this class are 2,2-bis-(4-glycidoxy-phenyl)-propane, 2,2-bis-(4-epoxyethoxy-phenyl)-propane, bis-glycidyl ether of tetra-chloro-bisphenol A, bis-glycidyl ether of tetra-bromo-bisphenol A, bis-oxiranyl ether of tetra-chloro-bisphenol A, and bis-oxiranyl ether of tetra-bromo-bisphenol A.

Another class of useful crosslinking agents is blocked polyisocyanates. Upon heating a blocked polyisocyanate, a blocking groups split off to yield a free reactive polyisocyanate. Useful polyisocyanates in the present invention include, toluene diisocyanate, isophorone diisocyanate, 1,4-naphthalene diisocyanate, 1,6-hexamethylene diisocyanate, tetramethyl xylene diisocyanate, bis (4-isocyanatocyclohexyl) methane and the like. Useful blocking groups are derived from caprolactam; diethyl malonate; alcohols; phenols; oximes, e.g., methyl ethyl ketoxime; and the like.

ADHESION PROMOTERS

When the photopolymerizable composition is to be used as a coating on a metal surface, such as a photoresist, a heterocyclic or mercaptan compound may be added to improve adhesion of the coating to a metal.

Suitable adhesion promoters include heterocyclics such as those disclosed in US PAT. NO. 3,622,334 to Hurley et al., US PAT. NO. 3,645,772 to Jones, and US PAT. NO. 4,710,262 to Weed. Examples of useful adhesion promoters include benzotriazole, 5-chloro-benzotriazole, 1-chloro- benzotriazole, 1-carboxy-benzotriazole, 1-hydroxy-benzotriazole, 1,2-napthotriazole, benzimidazole, mercaptobenzimidazole, 5-nitro-2-mercaptobenimidazole, 5-amino-2-mercyptobenzimidazole, 2-amino-benzimidazole, 5-methyl-benzimidazole, 4,5-diphenylbenzimidazole, 2- guanadino-benzimidazole, benzothiazole, 2-amino-6-methyl-benzothiazole, 2-mercaptobenzothiazole, 2-methyl- benzothiazole, benzoxazole, 2-mercaptobenzoxazole, 2- mercapthiazoline, benzotriazole, 3-amino-1,2,4- triazole, 1H-1,2,4-triazole-3-thiol, 5-amino-1,3,4- thiodiazole-2-thiol, 4-mercapto-IH-pyrazolo[3,4- d]pyrimidine, 4-hydroxy-pyrazolo [3,4-d]pyrimidene, 5-amino-tetrazole monohydrate, tolutriazole, 1-phenyl-3- mercapototetrazole, 2-amino-thiazole, and thiobenzanilide.

Preferred adhesion promoters for use in photoresists and solder masks include 2-amino-5-mercaptothiophene, 5-amino-1,3,4-thiodiazole-2-thiol, benzotriazole, 5-chloro-benzotriazole, 1-chloro-benzotriazole, 1-carboxy-benzotriazole, 1-hydroxy-benzotriazole, 2-mercaptobenzoxazole, 1 H-1,2,4-triazole-3-thiol, and mercaptobenzimidazole.

Optionally, the coverlay compositions of the present invention further comprise an adhesion promoter. The preferred adhesion promoters of the present invention comprise

a. a thiophene having an -H or -SH on the 2 position carbon (on one side of the sulfur) and an -NH$_2$ on the 5 position carbon (on the other side of the sulfur); and

b. a nitrogen substituted thiophene ring, wherein nitrogen is substituted at the thiophene ring:

i. 3 position;
ii. 4 position; or
iii. both the 3 position and the 4 position and

wherein -H or -SH on the 2 position carbon and an -NH$_2$ is on the 5 position carbon.

POLYMERIC MODIFIERS

The photopolymerizable composition may (optionally) contain a second polymeric binder to modify adhesion, flexibility, hardness, oxygen permeability, moisture sensitivity and other mechanical or chemical properties required during its processing or end use. Such modifiers can be particularly useful in adjusting room temperature creep viscosity, so the coverlay compositions of the present invention can be stored in a rollstock form, without unwanted creep or deformation.

Suitable polymeric binders which can be used in combination with the graft copolymer of this invention include: polyacrylate and alpha-alkyl polyacrylate esters, e.g., polymethyl methacrylate and polyethyl methacrylate; polyvinyl esters, e.g., polyvinyl acetate, polyvinyl acetate/acrylate, polyvinyl acetate/methacrylate and hydrolyzed polyvinyl acetate; ethylene/vinyl acetate copolymers; polystyrene polymers and copolymers, e.g., with maleic anhydride and esters;

vinylidene chloride copolymers, e.g., vinylidene chloride/acrylonitrile; vinylidene chloride/methacrylate and vinylidene chloride/vinyl acetate copolymers; polyvinyl chloride and copolymers, e.g., poly(vinyl chloride/vinyl acetate); polyvinyl pyrrolidone and copolymers, e.g., poly(vinyl pyrrolidone/vinyl acetate) saturated and unsaturated polyurethanes; synthetic rubbers, e.g., butadiene/acrylonitrile, acrylonitrile/butadiene/styrene, methacrylate/acrylonitrile/butadiene/styrene copolymers, 2-chlorobutadiene-1,3 polymers, chlorinated rubber, and styrene/butadiene/styrene, styrene/isoprene/styrene block copolymers; high molecular weight polyethylene oxides of polyglycols having average molecular weights from about 4,000 to 1,000,000; copolyesters, e.g., those prepared from the reaction product of a polymethylene glycol of the formula $HO(CH2)_nOH$ where n is a whole number 2 to 10 inclusive, and

> (1) hexahydroterephthalic, sebacic and terephthalic acids,
> (2) terephthalic, isophthalic and sebacic acids,
> (3) terephthalic and sebacic acids,
> (4) terephthalic and isophthalic acids,
> (5) mixtures of copolyesters prepared from said glycols
> (6) terephthalic, isophthalic, sebacic and adipic acid; nylons or polyamides, e.g., N-methoxymethyl polyhexamethylene adipamide; cellulose esters, cellulose acetate, cellulose acetate succinate and cellulose acetate butyrate; cellulose ethers, e.g., methyl cellulose, ethyl cellulose and benzyl cellulose; polycarbonates; polyvinyl acetal, e. g., polyvinyl butyral, polyvinyl formal; polyformaldehydes.

In the case where aqueous development of the photosensitive composition is desirable, the graft copolymer and/or the binder should contain sufficient acidic or other groups to render the composition processible in aqueous developer. Useful aqueous-processible binders include those disclosed in US PAT. NO. 3,458,311 and in US PAT. NO. 4,273,857.

Useful amphoteric polymers include interpolymers derived from N-alkylacrylamides or methacrylamides, acidic film-forming comonomer and an alkyl or hydroxyalkyl acrylate such as those disclosed in US PAT. NO. 4,293,635. For aqueous development the photosensitive layer will be removed in portions which are not exposed to radiation but will be substantially unaffected during development by a liquid such as wholly aqueous solutions containing 1 % sodium carbonate by weight. A specific, preferred class, of polymeric binder modifiers are polyvinyl pyrrolidone polymers and copolymers thereof, and amphoteric polymers and copolymers thereof.

PLASTICIZERS

The photopolymerizable compositions may also contain a plasticizer to modify adhesion, flexibility, hardness, solubility, and other mechanical or chemical properties required during its processing or end use. However, a dedicated plasticizer may not be necessary, particularly if plasticizer properties are obtained from other ingredients formulated into the coverlay for other purposes or functions.

Suitable plasticizers include triethylene glycol, triethylene glycol diacetate, triethylene glycol dipropionate, triethylene glycol dicaprylate, triethylene glycol dimethyl ether, triethylene glycol bis(2-ethylhexanoate), tetraethylene glycol diheptanoate, poly(ethylene glycol), poly(ethylene glycol) methyl ether, isopropylnaphthalene, diisopropylnaphthalene, poly(propylene glycol), glyceryl tributyrate, diethyl adipate, diethyl sebacate, dibutyl suberate, dioctyl phthalate, tricresyl phosphate, tributyl phosphate, tris(2-ethylhexyl) phosphate. The photolymerizable compositions may also contain particulates such a organic or inorganic fillers to modify the mechanical or chemical properties required during its processing or end use.

FILLERS

The photopolymerizable compositions may also contain suitable fillers. These fillers include organic or inorganic reinforcing agents that are essentially transparent, as disclosed in US PAT. NO. 2,760,863, e.g., organophilic silica bentonite, silica, and powdered glass having a particle size less than 0.4 mil. Other fillers are inorganic thixotropic materials as disclosed in US PAT. NO. 3,525,615, e.g., boehmite alumina, clay mixtures of highly thixotropic silicate oxide such as bentonite and finely divided thixotropic gel containing 99.5% silica with 0.5% mixed metallic oxide. Further fillers useful in the present invention are microcrystalline thickeners as disclosed in US PAT. NO. 3,754,920, e.g., microcrystalline cellulose, microcrystalline silicas, clays, alumina, bentonite, kalonites, attapultites, and montmorillonites. Another class of fillers includes finely divided powders having a particle size of 5 nanometers to 50 microns, preferably 5 nanometers to 500 nanometers, as disclosed in US PAT. NO. 3,891,441, such as silicon oxide, titanium oxide, carbon black, zinc oxide, and other commercially available pigments and the binder-associated, transparent, inorganic particles as disclosed in European Patent Application 87113013.4, such as magnesium silicate (talc), aluminum silicate (clay), calcium carbonate and alumina. Typically, the filler will be transparent to actinic radiation to preclude adverse effects during imaging exposure. Depending on its function in the photosensitive coverlay composition, the filler should be small particle size so that resolution and flexibility are not reduced. Fumed silica can provide such properties.

OPTIONAL COMPONENTS

Other compounds conventionally (or even non-conventionally) can be added to photosensitive compositions to modify the physical properties of the film for a particular use. Such components include: other polymeric binders, fillers, thermal stabilizers, hydrogen donors, thermal crosslinkers, optical brighteners, ultraviolet radiation materials, adhesion modifiers, coating aids, and release agents. Fillers, like inorganic particles, are useful in the present invention. If a substantial amount of filler, such as fumed silica, is used, the calculated Tg of the graft copolymer may be lower than the recommended 30°C to 80°C. This is because the fumed silica will change the tackiness of the coverlay and allow a lower Tg coverlay to slide more easily during lay-up. The photo polymerizable compositions may contain other components such as thermal polymerization inhibitors, dyes and pigments, optical brighteners and the like to stabilize, color or otherwise enhance the composition.

Thermal polymerization inhibitors that can be used in the photo polymerizable compositions are: p-methoxyphenol, hydroquinone, and alkyl and aryl-substituted hydroquinones and quinones, tert-butyl catechol, pyrogallol, copper resinate, naphthylamines, beta-naphthol, cuprous chloride, 2,6-di-tert-butyl-p-cresol, phenothiazine, pyridine, nitrobenzene and dinitrobenzene, p-toluquinone and chloranil. Also useful for thermal polymerization inhibitors are the nitroso compositions disclosed in US PAT. NO. 4,168,982.

Various dyes and pigments may be added to increase the visibility of the resist image. Any colorant used, however, should preferably be transparent to the actinic radiation used.

COATING LIQUIDS

The photoimageable, permanent coating may be coated as a liquid onto the printed circuit substrate using any conventional coating process. The liquid may be a solution or a dispersion of the permanent coating composition wherein the solvent is removed sufficiently, after coating, to form a tack-free coverlay layer. The additional layer or layers are coated sequentially and dried. The liquids may be spray coated, roller-coated, spin-coated, screen-coated or printed as disclosed in the Coombs patent discussed above, in the DeForest patent discussed above, in US PAT. NO. 4,064,287 to Lipson et al., or in US PAT. NO. 4,376,815 to Oddi et al. The liquid, typically as a solution, may also be curtain coated as disclosed in US PAT. NO. 4,230,793 to Losert et al. In the instance where printed circuits are manufactured on a continuous web of film substrate, permanent coating liquid may be coated by any conventional (or non-conventional) web coating process.

TEMPORARY SUPPORT FILM

Any of the support films generally known for use in photoresist films can be used. The temporary support film, which preferably has a high degree of dimensional stability to temperature changes, may be selected from a wide variety of polyamides, polyolefins, polyesters, vinyl polymers and cellulose esters, and may have a thickness ranging from 6 to 200 microns. A particularly preferred support film is polyethylene terephthalate having a thickness of about 25 microns. The temporary support film can be surface treated to improve release properties with substances such as silicones, providing the coating solution sufficiently wets the surface of the film to yield a uniform thickness coating. At least one surface of the support film may have a matte surface obtained by incorporation of filler particles in, or embossing the surface of, the temporary support film.

COVER FILM

The photoimageable permanent coating layer may be protected by a removable cover film in order to prevent blocking when the roll is stored. This cover film is removed prior to lamination. The protective cover film may be selected from the same group of high dimensional stable polymer films described for the temporary support film, supra, and may have the same wide range of thicknesses. A cover film of 15-30 microns thick polyethylene or polypropylene, polyethylene terephthalate or silicone treated polyethylene terephthalate, are especially suitable. At least one surface of the cover film may have a matte surface obtained either by incorporation of filler particles in, or embossing the surface of, the cover film.

## PHOTOIMAGEABLE COVERLAY PROCESS

Photoimageable permanent coatings can be used as a solder mask to protect printed circuits during subsequent processing, primarily solder operations, and/or from environmental effects during use. Permanent coatings also are used as intermediate insulative layers, with or without development, in the manufacture of multilayer printed circuits.

In practice, the photoimageable multilayer coating composition, typically between 15 and 50 micrometers (0.6 and 2 mils) thick, is applied to a printed circuit substrate which typically is a printed circuit relief pattern on a substrate that is semi-rigid or flexible. The photoimageable coating compositions may be sequentially coated as liquids and dried between layers or may be applied as a pre-coated multilayer composition on a temporary support. The multilayer composition is applied to a printed circuit substrate with vacuum lamination. The applied photopolymerizable composition is then imagewise exposed to actinic radiation to harden or insolubilize exposed areas. Any unexposed areas are then completely removed typically with an alkaline, aqueous sodium or potassium carbonate developer solution which selectively dissolves, strips, or otherwise disperses the unexposed areas without adversely affecting the integrity or adhesion of the exposed areas. The developed permanent resist image is typically cured at 160°C for 1 hour. After cure the circuit board has a cured permanent resist layer covering all areas except unexposed areas that have been removed by development. Electrical components are then inserted into the through-holes or positioned on surface mount areas and soldered in place to form the packaged electrical component.

## PERMANENT COATING EVALUTATION

Printed circuits must withstand a variety of tests that are dependent on the application of the circuits, which in turn governs the type of material used as the circuit substrate. A stringent application is for flexible printed circuits which require a fold or bend for a particular space requirement, such as a camera or video cassette recorder (VCR), and may require the capability of surviving multiple bends, such as in a computer disc drive. In some applications a flexible circuit is combined with a rigid circuit to form a flex-rigid multilayer printed circuit. The end use tests for flexible circuits focus on adhesion and the capability to withstand a single fold or multiple bends. The process and several tests that are used to support the examples in this application are described below.

## DRY FILM LAMINATION

A pre-formed, dry-film, photopolymerizable multilayer coating is applied, after removal of a removable cover sheet, e.g., polyethylene or polypropylene used to protect the permanent coating element during storage, to the pre-cleaned copper printed circuit surface of the substrate with a SMVL vacuum laminator. Although the laminate is typically imagewise exposed to actinic radiation through the temporary support film, in some instances, the temporary support may be removed before imaging to improve resolution and other such properties.

Typically, when a dry film is laminated without a liquid assist to a printed circuit substrate having a low circuit relief, measures must be taken to eliminate entrapped air, e.g., from around circuit lines. Entrapped air is eliminated by the vacuum lamination process described in US PAT. NO. 4,127,436 to Fiel, or may be eliminated by the grooved roll lamination process described in US PAT. NO. 4,071,367 to Collier et al. A Solder Mask Vacuum Laminator (SMVL) is useful in eliminating entrapped air, but this laminator is limited to atmospheric pressure lamination force after the evacuation cycle. If higher pressure is needed, the SMVL lamination can be followed by a hot press lamination, or alternatively a vacuum press can be used for the lamination.

## TIME TO CLEAR (TTC)

This test evaluates the retention time for adequately developing photoimageable coverlay. The multilayer coating is laminated onto a rigid or flexible substrate, then timed when placed through a 1% aqueous sodium carbonate or potassium carbonate developer solution (which should be at the same temperature as that used in actual processing, typically 26 to 40°C). The total "time to clear" is reported in seconds, beginning from the time the sample enters the developer and ending at the time at which the unexposed coverlay is washed off the substrate. Exposed samples are generally then developed at two times the time to clear.

## PHOTO SPEED

This test evaluates the processability of photoimageable coverlay. The photoimageable coverlay is laminated onto a substrate, then is exposed to 100 to 500 mj/cm$^2$ UV through a 21 $\sqrt{2}$ step Stouffer sensitivity photo-pattern. After the sample is developed, the resulting step-wedge pattern is analyzed. The last step containing photopolymer is used to calculate the amount of exposure to achieve 10 $\sqrt{2}$ step of photopolymer.

ENCAPSULATION

This test evaluates the capability of coverlay to adequately protect the substrate. The substrate and coverlay chosen for this test should represent those in end-use applications. The substrate is typically a circuit pattern and is processed with the coverlay exactly as is done in actual manufacturing. After processing, the sample is evaluated using 10X magnification for any air entrapment that constitutes a failure. In addition, the sample also may be cross-sectioned along the edge of a circuit line and evaluated using magnification to ensure that the photoimageable coverlay adequately covers the area with no "soda-strawing" defects. Before samples are processed further they should pass this encapsulation test.

CROSS-HATCH ADHESION

This test is performed according to ASTM D-3359-83, Method B. Test substrates are selected to duplicate the material typically used for end-use, and are processed to mirror actual processing.

Test substrates, typically a Pyralux® AP 8525 substrate with copper etched off of one side, are either chemically cleaned substrates or substrates used without any pre-cleaning or etching of the copper surface. The samples that are chemically cleaned are cleaned in a series of steps with immersion first in Versa Clean® 415 for 2 minutes at 45° to 50°C followed by immersion for 30 seconds in a deionized water bath. The samples are then immersed in Sure Etch® 550 micro etching solution for one minute at 35°C, followed by a deionized water rinse for 30 seconds. The samples are finally immersed in 10% sulfuric acid solution at room temperature for 30 seconds and given a final deionized water rinse. Samples are dried and placed immediately in a nitrogen atmosphere until used.

The test areas are a blank copper area and a blank adhesive area where the copper had previously been etched off. Specimens are tested "after cure" as well as "after solder" exposure, which simulates solder exposure during PCB fabrication. Typical "after solder" specimens are floated in 288°C 60/40 tin/lead solder for 30 seconds. Residual solder is then removed before evaluation. All specimens are scored with a 10 blade Gardco blade, then the sample is rotated 90° and rescored so that a cross-hatch pattern comprised of 100 squares is cut into the coverlay surface. Adhesive tape is applied and rubbed to ensure good contact, then pulled away at a 90° angle in a smooth fluid motion. The sample is examined using 10X magnification for delaminations. Pick off from the cutting blade of 1-2% is not considered a failure but >2% pickoff is a failed sample.

BEND AND CREASE

The substrate to be used for this test is typically a MIT flexural endurance pattern. The MIT pattern is a meander pattern that has alternating one millimeter lines and spaces in the region of the testing. The sample is creased in a 180° fold perpendicular to the direction of the lines and spaces. The substrate is typically the same type as that used in the actual product application. The thickness and type of substrate (copper, adhesive) and the processing steps (pre-clean, lamination, cure, solder exposure) are duplicated so that the evaluation reflects a true simulation. Typically a Pyralux® AP 8525 substrate is used with the copper etched off of one side. The polyimide thickness for this laminate is 2 mils and the copper thickness from the 0.5 oz/ft$^2$ copper layer is 18 micrometers. The CTE of the polyimide for this laminate is 23 ppm/°C +/-10%. Samples are bent and creased by hand in 10 different areas of each sample, then examined using 10X magnification for defects such as cracks or delaminations. Any reported defects constitute a failure. Samples are evaluated "after cure" and "after solder," in which case samples are floated, coverlay side up, in 288°C 60/40 tin/lead solder for 30 seconds, then cooled to room temperature and evaluated as described above.

TACK ASSESSMENT

Tack assessment is a measurement of the tackiness of the photo polymerizable coating prior to lamination. A quick method of evaluating tack is to remove the polyethylene coversheet and, while wearing a thin nitrile glove, apply a fingertip to the coating briefly (~1 second) to see if the coating has an altered appearance. Surface disruption indicates that the coating is soft, and may pre-tack to the substrate before laminating.

A more quantitative approach to measuring film tack is to rigidize the coating's polyethylene coversheet with a thick tape (to prevent stretch of the coversheet) and evaluate the peel strength between the green film and it's rigidized coversheet. Higher peel strengths are indicative of high tack. Using [-Mass Adhesion tester (180° peels), low tack films yield a typical peel strength number of < 10 N/mm.

Alternately, tack assessment can be done by removing the poly ethylene cover sheet of a piece of green film and laying it on top of a substrate, then trying to reposition the green film on the substrate. Tacky films will adhere to the substrate, making repositioning difficult or impossible to do without compromising the bond between the green film and it's base, 92D Mylar® film. Pre-tack can lead to lamination defects such as air entrapment and wrinkles.

ELECTROLESS NICKEL PLATING

Small circuit samples which contain 30 mil vias are used for this test. Samples are cleaned then nickel plated by immersion in the following chemical cleaning steps:

1 ) 2 minutes in VersaClean® 415 (a basic pre-plate cleaner) solution at 45°C
2) 1 minute in DI water rinse
3) 1 minute in Sure Etch® 550 solution at 35°C
4) 1 minute in DI water rinse
5) 1 minute in 10% sulfuric acid
6) 2 minutes in DI water rinse

The plating steps:

1 ) 2 minutes in 30°C Uyemura KAT-450 Activation bath (89% DI water, 1% sulfuric acid, 10% KAT-450 activator)
2) 45 second DI water rinse
3) 45 seconds in 5% $H_2SO_4$ (at room temperature)
4) 1 minute DI water rinse
5) 20 minutes in 80°C bath of Uyemura's electroless nickel plating bath of 15% by volume NPR-4-M (proprietary reducing agent, chelator and stabilizer), 4.5% by volume NPR-4-A (nickel metal solution, chelator), and 0.3% by volume NPR-4-D (proprietary composition of special additives that contain inorganic salts)
6) 2 minute DI water rinse.
7) Samples are then examined under 10X magnification for plating uniformity, haloing and delamination.

CREEP VISCOSITY

The polyethylene coversheets are removed and enough layers of film laminated together (room temperature/ hand pressure) to make 40 mil thick samples. The samples are condition at room temperature and 50% RH for 48 hours. A circular sample is cut about 1/4" in diameter and placed in the TMA, heated to 40°C with a 100g weight applied. The sample thickness is measured vs. time for 15 minutes.

MOLECULAR WEIGHT DETERMINATION

Molecular weights were obtained by size exclusion chromatography using THF as the eluting solvent and using polystyrene standards.

CALCULATED GLASS TRANSITION TEMPERATURE

A useful approach to assess whether a graft copolymer will yield low tack photoimageable coverlay is to use the Fox Equation to calculate the Tg. The Tg of the graft copolymer backbone, macromer and the Tg for the total graft copolymer can be calculated. Although this is only an approximation, and best results are obtained with high MW polymer, a good correlation of this method with coating tack was obtained with the graft copolymer examples.

FLAMMABILITY (UL94 TEST)

Specimens were tested in accordance with the UL 94 Thin Material Vertical Burning Test for classing resist coating materials as 94VTM-0, 94VTM-1 or 94VTM-2. The 94VTM-0 classification is the best rating, indicating significantly reduced flammability.

EXAMPLES

The advantages of the present invention are illustrated in the following examples. These examples are not intended to limit the scope of this invention. The compositions below are described in weight % for each ingredient used. The following glossary contains of list of names and abbreviations for each ingredient used:

| o-C1 HABI | Bis-(2-o-chloro-4,5-diphenylimidizole) |
| EMK | Ethyl Michler's ketone |
| Vazo® 52 | 2,2'-azobis (2,4-dimethylpentane-nitrile) from DuPont |
| Luperox® 554 M75 | 75% by weight solids of t-amyl peroxypivalate in mineral spirits from Elf Atochem |
| IRR-1031 | 75% by weight solids of bis-(3-acryloxyloxy-2-hyroxypropyl) ether of tetrabromo-bisphenol-A in ethyl acetate from UCB Chemicals Corp., Smyrna, GA |
| Ebecryl® 9119 | 75% by weight solids of urethane diacrylate from UCB Chemicals Corp., Smyrna, GA |
| Ebecryl® 9120 | 75% by weight solids of diacrylate of bisphenol-A diglycidyl ether from UCB Chemicals Corp., Smyrna, GA |
| CD-560 | Ethoxylated (3 EO) 1,6-hexanediol diacrylate from Sartomer Company, Exton, PA |
| Desmodur® BL3175 | Hexamethylene diisocyanate based polyisocyanate blocked with methyl ethyl ketoxime and dissolved at 75% solids in ethyl acetate |
| 5-ATT | 5-amino-1,3,4-thiadiazole-2-thiol from Aldrich Chemical Co. |
| 3-MT | 3-mercapto-1H,2,4-triazole from Esprit Chemical Co., Rockland, MA |
| Sevron® Blue GMF | Green dye from Crompton & Knowles Corp., Reading, PA |
| Basonyl® Blue Green | Green dye from Crompton & Knowles Corp., Reading, PA |
| PVP-K90 | Polyvinylpyrrolidone from GAF Chemicals Corp., Texas City, TX |

EXAMPLE 1

[70] FR-1025M /iBA/n-BA/HEA (0.4/0.3/0.2/0.1) [30] MMA/MAA (0.7125/0.2875)

A graft copolymer was prepared using a macromer prepared according to WO 94/21701. This disclosure is incorporated herein as a reference. The macromer was prepared as a solution. The macromer solution contained 43.3% solids dissolved in IPA. The macromer solids were 71.25 % by weight methyl methacrylate (MMA) and 28.75% by weight methacrylic acid (MAA). The number average molecular weight of the macromer was 1,500, and the weight average molecular weight of the macromer was 2,900.

The procedure was to place into a resin kettle, equipped with a mechanical stirrer and reflux condenser, 106.23 g of pentabromobenzyl acrylate (called FR-1025M a product of AmeriBrom Inc.) under a nitrogen blanket. Next, was added 231.48 g of macromer solution, 15.94 g of isobutyl acrylate, 53.17 g of n-butyl acrylate, 8.07 g of hydroxyethyl acrylate, and 115.71 g of toluene. This mixture was mildly heated and stirred to dissolve the FR-1025M. The solution was then sparged with nitrogen and heated to a constant 73°C. Next, 55.8 g of a nitrogen-sparged solution, containing 8.47 g of Luperox®-554 M75 in 53.03 g 2-butanone, was added over 240 minutes. 30 minutes later, after the initiator feed was started, 113.9 g of a second nitrogen-sparged solution, containing a monomer mixture of 33.21 g of macromer, 67.1 g of isobutyl acrylate, and 19.6 g of hydroxyethyl acrylate, was added over 120 minutes. After the initiator feed was complete, the total solution was heated to reflux at 82°C for 60 minutes.

At room temperature, the colorless, one-phase solution had a viscosity of 2,300 centi-poise (taken with a Brookfield viscometer model RVT using spindle number 4). The solids weight percent of the graft copolymer in the solvent was about 56.3 %. The acid number of dry graft copolymer was 55.5. The graft copolymer had a calculated Tg for the backbone of 25°C, and 51°C for the total graft copolymer. The calculated Tg for the macromer was 134°C. In the graft copolymer, the weight percent of the backbone portion was about 70% and the weight percent of the graft section, or comb portions, was about 30%. The number average molecular weight of the graft copolymer was about 11,000 and the weight average molecular weight was about 29,000.

EXAMPLE 2

[70] iBA /FR-1025M / HEA (0.5/0.4/0.1) [30] MMA/MAA (0.7125/0.2875)

A graft copolymer was prepared using the same macromer as in EXAMPLE 1. 1007.97 g of pentabromobenzyl acrylate (FR-1025M) was placed in a resin kettle with mechanical stirrer, reflux condenser and nitrogen blanket. To this was added 2197.0 g of macromer solution, 630.0 g of isobutyl acrylate, 126.01 g of hydroxyethyl acrylate, 404.4 g of toluene, and 236.6 g of 2-butanone.

This mixture was heated to 53°C with stirring to dissolve the FR-1025M. The solution was sparged with nitrogen and heated to reflux at 80°C. 18.3 g of a nitrogen-sparged solution containing, 2.69 g of Luperox®-554 M75 in 17.35 g 2-butanone, was added at once, followed by the addition of 325.64 g of a nitrogen-sparged solution containing, 57.51 g of Vazo® 52 in 300.75 g 2-butanone, over 240 minutes. 30 minutes after the initiator feed was started 1055.69 g of a nitrogen-sparged solution of a monomer mixture of 314.56 g macromer, 661.5 g of isobutyl acrylate, and 132.31 g of hydroxyethyl acrylate was added over 120 minutes. After the initiator feed was complete, the solution was heated to reflux at 80°C for 140 minutes. After cooling to room temperature, the colorless one-phase solution had a viscosity of 9,800 centi-poise, and a solids weight % of 60.6 %. The acid number of dry graft copolymer was 53.3. The graft copolymer had a calculated Tg for the backbone of 37°C and 61°C for the total graft copolymer. The calculated Tg for the macromer was 134°C. The number average molecular weight was 9,000 and the weight average molecular weight was 23,000.

EXAMPLE 3

[70] iBA /FR-1025M /HEA (0.5/0.4/0.1) [30] MMA/MAA (0.7125/0.2875)

A graft copolymer was prepared according to the procedure of EXAMPLE 2 except for the 4 changes listed below:

    1) all of the macromer was in the pot at the start of the reaction,
    2) toluene was replaced by 2-butanone as additional solvent,
    3) benzoyl peroxide replaced Luperox®-554 M75 at 0.08 wt. % based on monomer,
    4) half the initiator (Vazo®52) was used at 0.73 wt % based on monomer.

The colorless one-phase solution had a viscosity of 15,900 centi-poise. The solids weight % of the graft copolymer in solution was 60.5%. The acid number of dry polymer was 56.4. The graft copolymer has a calculated Tg for the backbone of 37°C and 61°C for the total graft copolymer. The calculated Tg for the macromer was 134°C. The number average molecular weight was 14,000 and the weight average molecular weight was 29,000.

EXAMPLE 4

[70] iBA /DBS /HEMA (0.52/0.38/0.1) [30] MMA/MAA (0.7125/0.2875)

A graft copolymer was prepared using the same macromer as in EXAMPLE 1. Instead of FR-1025M, dibromostyrene was used as the flame-retardant monomer. In a resin kettle with mechanical stirrer, reflux condenser and nitrogen blanket was added 240.26 g of macromer solution, 140.13 g of isobutyl acrylate, 20.68g dibromostyrene, 26.98 g of hydroxyethyl methacrylate and 83.92 g of 2-butanone. The solution was sparged with nitrogen and heated to reflux at 88°C. 53.0 g of a nitrogen-sparged initiator solution, containing 6.64 g of Luperox®-554 M75 in 51.76 g 2-butanone, was added over 180 minutes. 30 minutes after the initiator feed was started 108.7 g of a nitrogen-sparged solution of a monomer mixture of 28.13 g macromer and 86.51 g of dibromostyrene was added over 210 minutes. After initiator solution addition was complete, 26.7 g of a second initiator solution, containing 0.78 g of Luperox®-554 M75 in 28.45 g 2-butanone, was added over 90 minutes, at a reflux temperature of 82°C. After the second initiator feed was complete, the solution was heated to reflux at 82°C for 60 minutes.
At room temperature, the colorless one-phase solution had a viscosity of 1,800 centi-poise. The solids weight percent was 58.0%. The acid number of dry graft copolymer was 59.9. The graft copolymer has a calculated Tg for the backbone of 34°C and 59°C for the total graft copolymer. The calculated Tg for the macromer was 134°C. The number average molecular weight was 8,000 and the weight average molecular weight was 20,000.

EXAMPLE 5

[70] BENA/AN/iBA/ iBOA/HEA (0.35/0.25/0.2/0.1/0.1) [30] MMA/MAA (0.7125/0.2875)

A graft copolymer was prepared using the same macromer as in EXAMPLE 1. Into a resin kettle with mechanical stirrer, reflux condenser and nitrogen blanket were placed 234.98 g of macromer solution, 26.97 g of isobutyl acrylate, 47.19 g of benzyl acrylate, 13.4 g of hydroxyethyl acrylate, 13.44 g isobornyl acrylate, 33.67 g acrylonitrile and 108.58 g 2-butanone. This mixture was sparged with nitrogen and heated to 66°C with stirring. 3.44 g of a nitrogen-sparged solution of 0.28 g of Luperox®-554 M75 in 3.56 g 2-butanone was added at once, followed by the addition of 53.6 g of a nitrogen-sparged solution, of 6.08 g of Vazo® 52 in 52.69 g 2-butanone, over 240 minutes. 30 minutes after the initiator feed was started 166.8 g of a nitrogen-sparged solution of a monomer mixture of 33.68 g macromer, 28.29 g of isobutyl acrylate, 49.55 g benzyl acrylate, 14.17 g of hydroxyethyl acrylate, 14.15 g isobornyl acrylate, and 35.4 g acrylonitrile was added over 120 minutes. After the initiator feed was complete, the solution was heated to reflux at 80°C for 140 minutes.
At room temperature, the amber-colored one-phase solution had a viscosity of 2,500 centi-poise. The solids weight percent was 53.2%. The acid number of dry polymer was 55.1. The graft copolymer had a calculated Tg for the backbone of 24°C, and 50°C for the total graft copolymer. The calculated Tg for the macromer was 134°C. The number average molecular weight was 9,000 and the weight average molecular weight was 22,000.

EXAMPLE 6

The graft copolymer in EXAMPLE 1 was used to make the photosensitive coverlay composition below. Each coating solution was coated with a 4 mil doctor knife on 1 mil Mylar® film and dried 13 min in a forced draft oven set at 80°C to yield excellent encapsulation. Coatings were vacuum laminated to a chemically cleaned Teclam® 9120 copper laminate with a solder mask vacuum laminator at 80°C. Time to clear (TTC) in 1% aqueous sodium carbonate at 40°C was determined. The optimum exposure that is required to obtain 10 $\sqrt{2}$ steps of polymer image after development using a Stouffer $\sqrt{2}$ step wedge photo mask was determined. This optimum exposure was used for the EXAMPLES 6-11. Samples were exposed, developed at 2 times the time to clear unexposed material, and the developed samples were air dried and cured at 160°C for one hour. The processed samples were tested with immersion in 15% sulfuric acid at 40°C for 15 min, and electroless nickel plating.

| Ingredient | % by Weight |
|---|---|
| Graft copolymer 1 | 56.85 |
| IRR1031 | 14.88 |
| Ebecryl® 9119 | 13.65 |
| CD560 | 4.23 |
| Desmodur® BL3175 | 7.93 |
| o-Cl HABI | 0.33 |
| EMK | 0.08 |
| Benzophenone | 1.88 |
| Sevron Blue GMF | 0.04 |
| 5-ATT | 0.13 |

This sample passed crosshatch adhesion and bend/crease testing before and after a 30 second solder float at 288°C. Samples passed UL94VTM-0 flame retardancy testing on etched Teclam® 9120, which contains a flame-retardant adhesive. This sample was flame retardant due to being 16.6 weight percent bromine. The acid number of the photoimageable coverlay after coating was 27.3.

Results of EXAMPLE 6 are that the time to clear (TTC) was 21 seconds, the exposure was 141 mj/cm$^2$ and the thickness was 1.1 mils. The result of H$_2$SO$_4$ testing was that there was only a slight halo defect found by observation on the sample. During electroless nickel plating, the sample was observed to have plated well and uniformly.

EXAMPLE 7

This EXAMPLE was prepared in accordance with the procedure of EXAMPLE 6. The ingredients used were changed as follows:

| Ingredient | % by Weight |
|---|---|
| EXAMPLE 2 graft copolymer | 55.62 |
| IRR1031 | 15.31 |
| Ebecryl® 9119 | 14.04 |
| CD560 | 4.35 |
| Desmodur® BL3175 | 8.15 |
| o-Cl HABI | 0.34 |
| EMK | 0.08 |
| Benzophenone | 1.94 |
| Sevron Blue GMF | 0.04 |
| 5-ATT | 0.13 |

This sample passed crosshatch adhesion and bend/crease testing before and after a 30 second solder float at 288°C. Results of Example 10 are that the time to clear (TTC) was 52 seconds, the exposure was 350 mj/cm$^2$. The result of 15% sulfuric acid testing at 40°C for 15 minutes showed only a very minor haloing. During electroless nickel plating, the sample was observed to have plated well and uniformly. The acid number of the photoimageable coverlay after coating was 27.3.

EXAMPLE 8

This EXAMPLE was prepared in accordance with the procedure of EXAMPLE 6. The ingredients used were changed and a new adhesion promoter is shown:

| Ingredient | % by Weight |
|---|---|
| EXAMPLE 2 graft copolymer | 55.62 |
| IRR1031 | 15.31 |
| Ebecryl® 9119 | 14.04 |
| CD560 | 4.35 |
| Desmodur® BL3175 | 8.15 |
| o-Cl HABI | 0.34 |
| EMK | 0.08 |
| Benzophenone | 1.94 |
| Sevron Blue GMF | 0.04 |
| 2-amino-1,2,4-thiadiazole | 0.13 |

This sample passed crosshatch adhesion and bend/crease testing before and after a 30 second solder float at 288°C. Results of Example 11 are that the time to clear (TTC) was 43 seconds, the exposure was 1000 mj/cm$^2$. The result of 15% sulfuric acid testing at 40°C for 15 minutes showed only a very minor haloing. During electroless nickel plating, the sample was observed to have plated well and uniformly. The acid number of the photoimageable coverlay after coating was 27.3.

EXAMPLE 9

This EXAMPLE was prepared in accordance with the procedure of EXAMPLE 6. The ingredients used were changed and another new adhesion promoter is shown:

| Ingredient | % by Weight |
|---|---|
| EXAMPLE 2 graft copolymer 2 | 55.62 |
| IRR1031 | 15.31 |
| Ebecryl® 9119 | 14.04 |
| CD560 | 4.35 |
| Desmodur® BL3175 | 8.15 |
| o-Cl HABI | 0.34 |
| EMK | 0.08 |
| Benzophenone | 1.94 |
| Sevron Blue GMF | 0.04 |
| 2-amino-5-mercaptothiophene | 0.13 |

This sample passed crosshatch adhesion and bend/crease testing before and after a 30 second solder float at 288°C. Results of Example 12 are that the time to clear (TTC) was 42 seconds, the exposure was 500 mj/cm$^2$. The result of 15% sulfuric acid testing at 40°C for 15 minutes showed only a very minor haloing. During electroless nickel plating, the sample was observed to have plated well and uniformly. This sample performed better than EXAMPLES 7 and 8. The acid number of the photoimageable coverlay after coating was 27.3.

EXAMPLE 10

This EXAMPLE illustrates a graft copolymer-based photoimagable coverlay dry film that is expected to have excellent shelf like stability due to a reasonably high creep viscosity.

| Ingredient | % by Weight |
|---|---|
| EXAMPLE 3 graft copolymer | 43.18 |
| Acetone | 10.63 |
| IRR1031 | 12.14 |
| Ebecryl® 9119 | 11.14 |
| CD560 | 3.45 |
| Desmodur® BL3175 | 6.47 |
| o-Cl HABI | 0.27 |
| EMK | 0.06 |
| Benzophenone | 1.54 |
| Basonyl Blue Green | 0.03 |
| 5-ATT | 0.10 |
| PVPK-90 | 1.10 |
| Methanol | 9.90 |

This sample passed crosshatch adhesion and bend/crease testing before and after a 30 sec solder float at 288°C. A one mil coating was prepared and processed as EXAMPLE 6. Creep viscosity was measured to be 32 megapascals. TTC was 17 sec and 375 mj/cm$^2$ was the optimum exposure to achieve 10 $\sqrt{2}$ Stouffer steps after development. The acid number of the photoimageable coverlay after coating was 27.3.

EXAMPLE 11

This EXAMPLE illustrates the use of dibromostyrene as the flame-retardant monomer in the graft copolymer composition.

| Ingredient | % by Weight |
|---|---|
| EXAMPLE 4 graft copolymer | 56.13 |
| IRR1031 | 17.98 |
| Ebecryl® 9119 | 11.03 |
| CD560 | 4.30 |
| Desmodur® BL3175 | 8.06 |
| o-Cl HABI | 0.34 |
| EMK | 0.08 |
| Benzophenone | 1.91 |
| Sevron Blue GMF | 0.04 |
| 5-ATT | 0.13 |

A coating was prepared and processed as EXAMPLE 6. TTC was 40 sec and the exposure as defined by EXAMPLE 6 was 250 mj/cm$^2$. The cured 1.2 mil thick coating passed bend/crease testing after a solder float at 288°C for 30 sec., but 1 of 11 creases of an unsoldered sample cracked indicating that this composition, although fairly flexible, is not as flexible as EXAMPLES 6 to 10. This sample passed UL94VTM-0 flame retardancy testing on etched Teclam® 9120. The sample was flame retardant due to being 15.9 weight percent bromine. The acid number of the photoimageable coverlay after coating was 26.7.

EXAMPLE 12

The graft copolymer of EXAMPLE 12 is a halogen-free material that shows utility in a halogen-free photoimagable coverlay composition.

| Ingredient | % by Weight |
|---|---|
| EXAMPLE 5 graft copolymer | 58.25 |

(continued)

| Ingredient | % by Weight |
|---|---|
| Ebecryl® 9120 | 17.11 |
| Ebecryl® 9119 | 10.5 |
| CD560 | 4.09 |
| Desmodur® BL3175 | 7.67 |
| o-Cl HABI | 0.32 |
| EMK | 0.08 |
| Benzophenone | 1.82 |
| Sevron Blue GMF | 0.04 |
| 5-ATT | 0.12 |

A coating was prepared and processed as EXAMPLE 6. TTC was 17 sec and the exposure, as defined in EXAMPLE 6 was 200 mj/cm$^2$. The cured 1.2 mil thick coating passed bend/crease testing before and after a solder float at 288°C for 30 sec. The sample passed a 15 minute immersion in 15% sulfuric acid, and electroless nickel-plating testing at 40°C without haloing. The acid number of the photoimageable coverlay after coating was 27.3.

COMPARATIVE EXAMPLE 1

[73] nBA /DBS /HEA (0.55/0.35/0.1) [27] MMA/MAA (0.7125/0.2875)

In a resin kettle with mechanical stirrer, reflux condenser and nitrogen blanket was added 218.45 g of the same macromer solution as used in EXAMPLE 1. Also, 30.46 g of a monomer blend of 144.74 g of n-butyl acrylate, 92.1g dibromostyrene, 26.96 g of hydroxyethyl acrylate and 170.44 g of 2-propanol was added. The solution was heated to reflux at 83°C. 10.9 g of a first initiator solution, containing 1.75 g of Luperox® 11 in 9.30 g 2-propanol, was added over 17 minutes. After was added 23.38 g of a solution containing 1.93 g of Vazo®52 in 2.32 g of 2-butanone and 21.41 g 2-propanol, over 240 minutes. 30 minutes after the Vazo®52 initiator feed was started, 224.68 g of the monomer blend mixture was added over 180 minutes. After the first initiator solution was added, 19.6 g of a second initiator solution containing, 3.87 g of Vazo®52 in 13.26 g 2-propanol, was added over 15 minutes at reflux temperature of 85°C. After the second initiator feed was complete, the solution was heated to reflux at 84°C for 120 minutes.
At room temperature, the colorless one-phase solution had a viscosity of 1,100 centi-poise. The solids weight percent was 48.6%. The acid number of dry graft copolymer was 50.6. The graft copolymer had a calculated Tg for the backbone of -11°C and 20°C for the total graft copolymer. The calculated Tg for the macromer was 134°C. The number average molecular weight was 9,000 and the weight average molecular weight was 22,000. Here, the graft copolymer glass transition is too low in both the branched polymer segment and the total polymer.

COMPARATIVE EXAMPLE 2

[70] iBA /DBS /HEMA (0.52/0.38/0.1) [30] MMA/MAA (0.7125/0.2875)

A higher molecular weight macromer solution (prepared according to WO 94/21701) of the same composition as in EXAMPLE 1 was used. This was 43.3% solids in 2-propanol. The macromer had a number average molecular weight of 4,100 and weight average molecular weight of 10,300. In a resin kettle with mechanical stirrer, reflux condenser, and nitrogen blanket, was added the following components. 213.5 g of macromer solution, 58.4 g of isobutyl acrylate, 109.05 g of 2-butanone, and 105.94 g of a monomer mix containing, 56.21 g macromer solution, 85.94 g of isobutyl acrylate, 107.59 g of dibromostyrene and 28.2 g of hydroxyethyl methacrylate. The solution was sparged with nitrogen and heated to a controlled temperature of 73°C. 54.5 g of a nitrogen-sparged initiator solution containing 8.47 g of Luperox®-554 M75 in 51.48 g 2-butanone was added over 240 minutes. 30 minutes after the initiator feed was started, 158.76 g of a nitrogen-sparged solution of the monomer mixture was added over 120 minutes. After the initiator feed was complete, the solution was heated to reflux at 78°C for 60 minutes.
At room temperature, the colorless one-phase solution had a viscosity of 5,900 centi-poise. The solids weight percent was 55.2%. The acid number of dry graft copolymer was 57.0. The graft copolymer had a calculated Tg for the backbone of 34°C and 59°C for the total graft copolymer. The calculated Tg for the macromer was 134°C. The number average molecular weight was 15,000 and the weight average molecular weight was 34,000. Here, the weight average molecular weight of the graft copolymer is too high which when made into a photoimagable coverlay formulation, will provide too much post-development residue.

COMPARATIVE EXAMPLE 3

[57] nBA /DBS /HEA (0.55/0.35/0.1) [43] MMA/MAA (0.5/0.5)

A macromer of 50/50 methyl methacrylate (MMA)/methacrylic acid (MAA), prepared according to EXAMPLE 1, was used. This macromer was 42.9% solids in 2-propanol. It had a number average molecular weight of 3,300. In a resin kettle with mechanical stirrer, reflux condenser and nitrogen blanket was added 510.93 g of macromer, 68.18 g of a monomer mixture containing 187.36 g of n- butyl acrylate, 34.1 g of hydroxyethyl acrylate, 119.44 g of dibromostyrene, and 475.34 g 2-butanone. This was refluxed at 68°C. 83 g of a solution containing 15.9 g of Luperox®-554 M75 in 67.88 g 2-butanone was added over 240 minutes. 30 minutes after the initiator feed was started, 272.12 g of the monomer mixture was added over 120 minutes. After the initiator feed was complete, the solution was heated to reflux at 68°C for 100 minutes.

At room temperature, the colorless one-phase solution had a viscosity was 900 centi-poise. The solids weight percent was 43.7% and the acid number of dry graft copolymer was 126.8. The graft copolymer had a calculated $T_g$ for the backbone of -6°C and 46°C for the total graft copolymer. The calculated Tg for the macromer was 159°C. The number average molecular weight of the graft copolymer was 11,000 and the weight average molecular weight of the graft copolymer was 23,000. Here the acid number is too high and will leave post development residue in a photoimagable coverlay formulation.

COMPARATIVE EXAMPLE 4

This COMPARATIVE EXAMPLE indicates the need for an 'above room temperature' Tg for the graft copolymer in order to achieve a relatively 'low tack' coating after drying. Low tack of the coating is required so that excessive pre-tack does not occur during the vacuum lamination. The graft copolymer in EXAMPLE 15 has a calculated Tg for the backbone of-11°C and has a calculated Tg of 20°C for the total graft copolymer.

| Ingredient | % by Weight |
|---|---|
| Graft copolymer comparative 1 | 60.79 |
| IRR1031 | 16.26 |
| Ebecryl® 9119 | 7.64 |
| CD560 | 5.73 |
| Desmodur® BL3175 | 7.32 |
| o-Cl HABI | 0.30 |
| EMK | 0.07 |
| Benzophenone | 1.74 |
| Sevron Blue GMF | 0.04 |
| 3-MT | 0.12 |

A coating was prepared and processed as EXAMPLE 6, but the coating was very tacky after drying and the sample significantly 'tacked down' to the flex circuit before vacuum lamination. This tack down made it very difficult to reposition the coating, as it is often needed, before the vacuum lamination step. The TTC was 24 seconds and the exposure, as defined in EXAMPLE 6 was 50 mj/cm$^2$. The cured 1 mil thick coating passed bend/crease testing before and after a solder float at 288°C for 30 seconds. The acid number of the photoimageable coverlay after coating was 24.5.

COMPARATIVE EXAMPLE 5

This COMPARATIVE EXAMPLE illustrates the difficulty of using too high a macromer molecular weight in the graft copolymer synthesis. This leads to processed samples that have post development residue. Post development residue hinders immersion nickel plating.

| Ingredient | % by Weight |
|---|---|
| Graft copolymer comparative 2 | 57.29 |
| IRR 1031 | 17.50 |

(continued)

| Ingredient | % by Weight |
|---|---|
| Ebecryl® 9119 | 10.74 |
| CD560 | 4.19 |
| Desmodur® BL3175 | 7.85 |
| o-Cl HABI | 0.33 |
| EMK | 0.08 |
| Benzophenone | 1.86 |
| Sevron Blue GMF | 0.04 |
| 5-ATT | 0.12 |

A coating was prepared and processed as EXAMPLE 6. TTC was 15 seconds and the exposure, as defined in EXAMPLE 6, was 100 mj/cm$^2$. The cured 1.1 mil thick coating passed bend/crease testing before and after a solder float at 288°C for 30 seconds. The sample passed crosshatch adhesion before solder exposure, but had 5 % delamination after a solder float at 288°C for 30 seconds. Due to too much post development residue, the sample did not immersion nickel plate. The acid number of the photoimageable coverlay after coating was 27.3.

COMPARATIVE EXAMPLE 6

This comparative example illustrates a problem when using a macromer with too high an acid number. Poor resistance to immersion nickel plating and sulfuric acid is observed.

| Ingredient | % by Weight |
|---|---|
| Graft copolymer comparative 3 | 63.29 |
| IRR 1031 | 15.22 |
| Ebecryl® 9119 | 7.15 |
| CD560 | 5.37 |
| Desmodur® BL3175 | 6.85 |
| o-Cl HABI | 0.29 |
| EMK | 0.07 |
| Benzophenone | 1.63 |
| Sevron Blue GMF | 0.03 |
| 3-MT | 0.10 |

A coating was prepared and processed as EXAMPLE 6. TTC was 12 seconds and the exposure, as defined by EXAMPLE 6, was 100 mj/cm$^2$. The cured 1.1 mil thick coating passed bend/crease testing before and after a solder float at 288°C for 30 seconds. The sample passed crosshatch adhesion before solder exposure, but the sample had 30 % delamination on the cut edges after a solder float at 288°C for 30 seconds. The sample also had haloing after sulfuric acid testing and de-laminated during electroless nickel plating. The acid number of the photoimageable coverlay after coating was 67.9.

COMPARATIVE EXAMPLE 7

Different procedures were used to attempt to prepare a single-phase polymer solution of the monomer composition of the EXAMPLE 2 graft copolymer. Different monomer and initiator addition rates, initiator levels and different solvent mixtures were investigated. Only two-phase solutions were obtained. This was observed by placing a sample of the final synthesized polymer mixture in a clear glass bottle, and the sample was allowed to stand overnight. In some cases, the samples took several days before the layers were totally separated. Unlike the graft copolymer, synthesis of a linear polymer of this composition is difficult or impossible to control to achieve a single-phase polymer solution. The graft copolymer has the advantage that the grafted on macromer makes the highly hydrophobic graft copolymer backbone compatible with the hydrophilic functionality from the macromer. A linear copolymer 2 prepared with the monomers of Example 2 graft copolymer yielded a mixture that was 53.3 wt % solids and separated into two layers. A sample of well-mixed material was used to prepare a photoimageable coverlay.

| Ingredient | % by Weight |
|---|---|
| Linear copolymer 2 | 57.30 |
| IRR1031 | 14.73 |
| Ebecryl® 9119 | 13.51 |
| CD560 | 4.18 |
| Desmodur® BL3175 | 7.85 |
| o-Cl HABI | 0.33 |
| EMK | 0.08 |
| Benzophenone | 1.86 |
| Sevron Blue GMF | 0.04 |
| 5-ATT | 0.12 |

This COMPARATIVE EXAMPLE shows the problems associated with using the same monomers in a linear polymer formulation as opposed to a graft copolymer. If two-phase graft copolymer is used to prepare a photoimagable coverlay, an incompatible composition results with poor coating quality. This poor coating quality consists of a non-uniform appearance and unreliable photoimagable test properties. The acid number of the photoimageable coverlay after coating was 27.3.

COMPARATIVE EXAMPLE 8

A comparison of immersion nickel-plating performance of commercially available photoimageable coverlay, Pyralux® PC1010, with EXAMPLE 6 was made. Pyralux® PC1010 was processed as EXAMPLE 6. The acid number of the photoimageable coverlay after coating was 32. TTC was 17 sec and the exposure as defined in EXAMPLE 6 was 200 mj/cm$^2$. The 1 mil thick cured coating passed bend/crease and crosshatch adhesion testing before and after a solder float at 288°C for 30 sec. The sample delaminated during immersion nickel plating. In contrast EXAMPLE 6 electroless nickel plated well with no delaminations or haloing.
Where the preceding text provides several numerical alternatives for any given parameter, each and every numerical value (including all intervening values) is specifically included in the scope of the invention.
Where several numerical alternatives are given for the lower limit of a range and for the upper limit of a range, ranges defined by each and every lower limit in combination with each and every upper limit are specifically included in the scope of the invention.

**Claims**

1.   A photosensitive coverlay composition

(a) comprising a graft copolymer component having at least one arm segment pendant to at least one backbone segment,
(b) the weight average molecular weight ratio ($M_{W1}$:$M_{W2}$) of said backbone segment to said arm segment being from about 1:0.033 to about 1:3,
(c) the arm segment being derived at least in part from at least one ethylenically unsaturated macromer component having a weight average molecular weight ($M_w$) of from 2,000 to 15,000,
(d) the graft copolymer component having an acid number of from 40 to 80, when dried of solvent, and
(e) the graft copolymer component having a calculated glass transition temperature (Tg) in a range from about 30°C to about 80°C.

2.   A composition in accordance with Claim 1, wherein the graft copolymer acid number is within a range of about 50 to about 60.

3.   A composition in accordance with Claim 1, wherein the calculated glass transition temperature (Tg) of the graft copolymer is from about 50°C to about 70°C.

4.   A composition in accordance with Claim 1, wherein the backbone segment has a calculated glass transition temperature (Tg) of from about 20°C to about 50°C.

**5.** A composition in accordance with Claim 1, wherein the arm segment is derived from a polymer or an oligomer having at least two repeating monomer units, the arm segment being attached to the backbone segment by a covalent bond.

**6.** A composition in accordance with Claim 1, wherein the or each arm segment has a calculated glass transition temperature (Tg) of from about 90°C to about 200°C.

**7.** A composition in accordance with Claim 1, wherein the arm segment(s) has a calculated glass transition temperature (Tg) of from about 110°C to about 160°C.

**8.** A composition in accordance with Claim 1, wherein the overall molecular weight (Mw) of the graft copolymer is in a range beginning at 20,000 and ending at 60,000.

**9.** A composition in accordance with Claim 1, wherein the arm segment has a weight average molecular weight (Mw) in a range from 2,000 to about 4,000.

**10.** A composition in accordance with Claim 1, wherein the number average molecular weight of the graft copolymer is in a range from 8,000 to 30,000.

**11.** A composition in accordance with Claim 1, wherein the number average molecular weight of the arm segment is in the range of about 1,000 to 5,000.

**12.** A composition in accordance with Claim 1, wherein at least a portion of the backbone segment is derived from pentabromobenzyl acrylate (PBA), isobutyl acrylate (iBA), n-butyl acrylate (nBA), or hydroxyethyl acrylate (HEA).

**13.** A composition in accordance with Claim 1, wherein at least a portion of the backbone segment is derived from dibromostyrene (DBS), isobutyl acrylate (iBA), or hydroxyethyl methacrylate (HEMA).

**14.** A composition in accordance with Claim 1, wherein at least a portion of the backbone segment is derived from benzyl acrylate (BENA), acrylonitrile (AN), isobutyl acrylate (iBA), isobornyl acrylate (iBOA), or hydroxyethyl acrylate (HEA).

**15.** A composition in accordance with Claim 1, wherein at least a portion of the backbone segment is derived from dibromostyrene (DBS), n-butyl acrylate (nBA), and hydroxyethyl acrylate (HEA).

**16.** A composition in accordance with Claim 1, wherein at least a portion of the backbone segment is derived from dibromostyrene (DBS), isobutyl acrylate (iBA), and hydroxyethyl methacrylate (HEMA).

**17.** A composition in accordance with Claim 1, wherein the graft copolymer is derived from acidic monomer and non-acidic monomer to provide an acidic monomer portion and a non-acidic monomer portion, wherein the weight percent of the acidic monomer portion, based upon the total acidic and non-acidic portions, is in a range of from about 5. to about 10%.

**18.** A composition in accordance with Claim 17, wherein at least 50 weight percent of the acidic monomer portion is located in the arm segment, and the balance of the acidic monomer portions are located in the backbone segment.

**19.** A composition in accordance with Claim 17, wherein at least 75, weight percent of the acidic monomer portion is located in the arm segment, and the balance of the acidic monomer portions are located in the backbone segment.

**20.** A composition in accordance with Claim 17, wherein the graft copolymer is derived in part from methyl methacrylate (MMA) and methacrylic acid (MAA) to provide a methyl methacrylate (MMA) portion and a methacrylic acid (MAA) portion.

**21.** A composition in accordance with Claim 20, wherein the weight ratio of the methyl methacrylate (MMA) portion to the methacrylic acid (MAA) portion is C/D, wherein C is from 40, to 90, and D is from 60 to 10.

**22.** A composition in accordance with Claim 20, wherein the weight percent of the graft copolymer multiplied by the weight fraction of the methacrylate acid (MAA) portion is a number with in the range of 5.5 to 11.5.

**23.** A composition in accordance with Claim 20 wherein for a given weight percent of the arm segment(s) in the graft copolymer, the weight fraction of methacrylic acid (MAA) portion in the arm segment(s) is as follows:

| Wt % arm segment | Wt fraction (MAA) portion in arm segment |
|---|---|
| 10 | 0.87 |
| 20 | 0.435 |
| 30 | 0.29 |
| 40 | 0.2175 |
| 50 | 0.174 |

**24.** A photosensitive coverlay composition in accordance with Claim 1 further comprising at least one addition polymerization monomer, at least one photo-initiator or photo-sensitizer, at least one thermal crosslinker, and at least one adhesion promoter.

**25.** A photosensitive coverlay composition in accordance with Claim 24, wherein the photosensitive coverlay composition has an acid number of from 15 to 50.

**26.** A photosensitive coverlay composition in accordance with Claim 24 wherein the addition polymerization monomer is selected from the group consisting of hexamethylene glycol diacrylate, ethoxlated 1,6-hexanediol diacrylate, acrylated aromatic urethane oligomer, triethylene glycol diacrylate, tripropylene glycol diacrylate, pentaerythritol triacrylate, trimethylolpropane triacrylate, polyoxyethylated trimethylolpropane triacrylate, di-(3-acryloxy-2-hydroxypropyl) ether of bisphenol-A, di-(3-acryloxy-2-hydroxypropyl) ether of tetrabromo-bisphenol-A, and methacrylate analogues of di-(3- acryloxy-2-hydroxypropyl) ether of tetrabromo-bisphenol-A.

**27.** A photosensitive coverlay composition in accordance with Claim 24 wherein the photo-initiator is selected from the group consisting of hexaarylbiimidazoles (HABI), benzophenone, Michler's ketone, ethyl Michler's ketone, p-dialkylaminobenzaldehydes, p-dialkylaminobenzoate alkyl esters, polynuclear quinones, thioxanthones, cyclohexadienones, benzoin, benzoin dialkyl ethers, or combinations thereof wherein the alkyl group contains 1 to 4 carbon atoms.

**28.** A photosensitive coverlay composition in accordance with Claim 24 wherein the thermal crosslinker is either a compound containing two or more epoxy groups or a blocked polyisocyanate.

**29.** A photosensitive coverlay composition in accordance with Claim 28 wherein the blocked polyisocyanate, upon heating, forms a polyisocyanate selected from the group consisting of toluene diisocyanate, isophorone diisocyanate, 1,4-naphthalene diisocyanate, 1,6-hexamethylene diisocyanate, tetramethyl xylene diisocyanate, bis (4-isocyanatocyclohexyl) methane.

**30.** A photosensitive coverlay composition in accordance with Claim 24 wherein the adhesion promoter is:

(a.) a thiophene ring having an -H or -SH on the 2 position carbon and an $-NH_2$ on the 5 position carbon;
(b.) a nitrogen substituted thiophene ring, wherein nitrogen is substituted at the thiophene ring:

i. 3 position;
ii. 4 position; or
iii. both the 3 position and the 4 position; and

wherein -H or -SH on the 2 position carbon and an $-NH_2$ is on the 5 position carbon.

**31.** A photosensitive coverlay composition in accordance with Claim 24 wherein the adhesion promoter is selected from the group consisting of 2-amino-5-mercaptothiophene, 5-amino-1,3,4-thiodiazole-2-thiol, benzotriazole, 5-chloro-benzotriazole, 1-chloro-benzotriazole, 1-carboxy-benzotriazole, 1-hydroxy-benzotriazole, 2-mercaptobenzoxazole, 1 H-1,2,4-triazole-3-thiol, and mercaptobenzimidazole.

**32.** A photosensitive coverlay composition in accordance with Claim 24 further comprising a polymeric binder modifier selected from the group consisting of polyvinyl pyrrolidone polymers and copolymers thereof.

**33.** A photosensitive coverlay composition in accordance with Claim 24 further comprising a filler having a particle size from 5 nanometers to 500 nanometers.

**34.** A photosensitive coverlay composition in accordance with Claim 33 wherein the filler is fumed silica.